# EUROPEAN PATENT APPLICATION

(11) **EP 3 979 002 A1**
(43) Date of publication of application: **06.04.2022**
(21) Application number: 20815273.6
(22) Date of filing: 25.05.2020
(51) Int. Cl.: G03F 7/004, G03F 7/027, H05K 1/03, H05K 3/46

(54) **PHOTOSENSITIVE RESIN COMPOSITION, PHOTOSENSITIVE RESIN FILM, MULTILAYER PRINTED WIRING BOARD, SEMICONDUCTOR PACKAGE, AND METHOD FOR PRODUCING MULTILAYER PRINTED WIRING BOARD**

(30) Priority: 31.05.2019 JP 2019102942
(71) Applicant: Showa Denko Materials Co., Ltd., Tokyo 100-6606 (JP)
(72) Inventor: SAWAMOTO, Hayato, Tokyo 100-6606 (JP); NAKAMURA, Akihiro, Tokyo 100-6606 (JP); TAKASE, Yuji, Tokyo 100-6606 (JP); NOMOTO, Shuji, Tokyo 100-6606 (JP); OKADE, Shota, Tokyo 100-6606 (JP)
(74) Representative: Hoffmann Eitle
(86) International application number: PCT/JP2020/020615
(87) International publication number: WO 2020/241596

(57) **Abstract**

The present invention relates to provision of a photosensitive resin composition, a photosensitive resin composition for photo via formation, and a photosensitive resin composition for interlayer insulating layer, each of which is excellent in both photosensitive characteristics and strippability from a support film. In addition, the present invention relates to provision of a photosensitive resin film and a photosensitive resin film for interlayer insulating layer, each of which is composed of the aforementioned photosensitive resin composition. Furthermore, the present invention relates to provision of a multilayer printed wiring board and a semiconductor package, and to provision of a method for producing the aforementioned multilayer printed wiring board. Specifically, the photosensitive resin composition is a photosensitive resin composition containing (A) a photopolymerizable compound having an ethylenically unsaturated group, (B) a photopolymerization initiator, and (C) a thermosetting resin, wherein the photopolymerizable compound (A) having an ethylenically unsaturated group includes (A1) a photopolymerizable compound having an acidic substituent and an alicyclic structure together with an ethylenically unsaturated group; and further, the thermosetting resin (C) includes (C 1) a thermosetting resin having an alicyclic structure, and the content of the component (C1) is 10 parts by mass or more based on 100 parts by mass of the component (A).

## Description

### Technical Field

The present disclosure relates to a photosensitive resin composition, a photosensitive resin film, a multilayer printed wiring board, a semiconductor package, and a method for producing a multilayer printed wiring board.

### Background Art

In recent years, miniaturization and increase of performance of electronic instruments are advanced, and in multilayer printed wiring boards, densification owing to an increase of the number of circuit layers and refinement of wirings proceeds. In particular, densification of a semiconductor package substrate on which a semiconductor chip is mounted, such as BGA (ball grid array) and CSP (chip size package) is conspicuous, and in addition to the refinement of wiring, thinning of an insulating film and more reduction in diameter of a via for interlayer connection (also referred to as "via hole") are demanded.

As a production method of a printed wiring board, there is exemplified a production method of a multilayer printed wiring board by a build-up method for successively laminating an interlayer insulating layer and a conductor circuit layer to form a multilayer printed wiring board (see, for example, PTL 1). In the multilayer printed wiring board, following the refinement of a circuit, a semi-additive process for forming a circuit by means of plating becomes the mainstream.

In the conventional semi-additive process, for example, (1) a thermosetting resin film is laminated on a conductor circuit, and the thermosetting resin film is cured upon heating, to form an "interlayer insulating layer". (2) Subsequently, a via for interlayer connection is formed by means of laser processing, followed by performing a desmear treatment and a roughening treatment by means of an alkaline permanganate treatment, etc. (3) Thereafter, a substrate is subjected to an electroless copper plating treatment, and after forming a pattern using a resist, a copper electroplating treatment is performed to form a circuit layer of copper. (4) Subsequently, resist stripping is performed, and flash etching of the electroless layer is performed, whereby a circuit of copper is formed.

As mentioned above, the laser processing is the mainstream as a method for forming a via in the interlayer insulating layer formed upon curing the thermosetting resin film. However, the reduction in diameter of a via by means of laser irradiation using a laser processing machine reaches the limit. Furthermore, in forming a via by a laser processing machine, it is needed to form the respective via holes one by one, and in the case where it is needed to form a large number of vias by means of densification, there is involved such a problem that a lot of time is required for forming the vias, so that the production efficiency is poor.

Under such circumstances, as a method in which a large number of vias can be collectively formed, there is proposed a method of collectively forming a plurality of reduced-diameter vias by the photolithography method by using a photosensitive resin composition containing (A) an acid-modified vinyl group-containing epoxy resin, (B) a photopolymerizable compound, (C) a photopolymerization initiator, (D) an inorganic filler, and (E) a silane compound, in which the content of the inorganic filler (D) is 10 to 80% by mass (see, for example, PTL 2).

In PTL 2, it is considered to be one of issues to suppress a lowering of the adhesion strength to plated copper to be caused due to use of the photosensitive resin composition as a material of the interlayer insulating layer or surface protective layer in place of the conventional thermosetting resin composition and further considered to be an issue of resolution of via and adhesion between the substrate of a silicon material and a chip component, and it is mentioned that these issues were solved. However, in a photosensitive resin film (dry film) formed of the conventional photosensitive resin composition, there is a tendency that its stripping force to a support film becomes high. Therefore, during thermally transferring the photosensitive resin film onto the base material while pressuring bonding the support film-provided photosensitive resin film using a laminator, the photosensitive layer forming the photosensitive resin film occasionally partially remains the support film. In that case, a defect is generated on the image pattern (via) formed on the photosensitive resin film by the photolithography, thereby possibly causing a reduction of resolution of via.

As a method for solving such a problem, there is known a method for adding a stripping agent in the photosensitive resin composition (see, for example, paragraph [0078] of PTL 3). Certainly, strippability between the photosensitive layer and the support film is improved by addition of the stripping agent; however, in the foregoing method, it is difficult to make both the strippability from a support film and the photosensitive performance compatible with each other. Specifically, it is known that when the addition amount of the stripping agent in the photosensitive layer is low, the strippability from a support film becomes insufficient, whereas when the addition amount of the stripping agent is increased, there is a tendency that photosensitive characteristics, such as sensitivity and resolution of the photosensitive layer, are lowered (see, for example, paragraph[0010] of PTL 4). Thus, the development of a photosensitive resin composition in which the photosensitive characteristics and the strippability from a support film are made compatible with each other is earnestly desired.

### Citation List

### Patent Literature

PTL 1: JP 7-304931 A
PTL 2: JP 2017-116652 A
PTL 3: JP 2008-529080 A
PTL 4: JP 2012-226148 A

### Summary of Invention

### Technical Problem

Then, a problem of the present invention is to provide a photosensitive resin composition, a photosensitive resin composition for photo via formation, and a photosensitive resin composition for interlayer insulating layer, each of which is excellent in both photosensitive characteristics and strippability from a support film. In addition, another problem of the present invention is to provide a photosensitive resin film and a photosensitive resin film for interlayer insulating layer, each of which is composed of the aforementioned photosensitive resin composition, to provide a multilayer printed wiring board and a semiconductor package, and to provide a method for producing the aforementioned multilayer printed wiring board.

### Solution to Problem

In order to solve the aforementioned problems, the present inventors made extensive and intensive investigations. As a result, it has been found that the aforementioned problems can be solved by a photosensitive resin composition containing components (A) to (C) as mentioned later, the component (A) including "(A1) a photopolymerizable compound having an acidic substituent and an alicyclic structure together with an ethylenically unsaturated group", and further, the thermosetting resin (C) including a predetermined amount of (C1) a thermosetting resin having an acyclic structure.

Specifically, the present invention relates to the following [1] to [19].
[1] A photosensitive resin composition containing (A) a photopolymerizable compound having an ethylenically unsaturated group, (B) a photopolymerization initiator, and (C) a thermosetting resin, wherein
   the photopolymerizable compound (A) having an ethylenically unsaturated group includes (A1) a photopolymerizable compound having an acidic substituent and an alicyclic structure together with an ethylenically unsaturated group; and further, the thermosetting resin (C) includes (C1) a thermosetting resin having an alicyclic structure, and the content of the component (C1) is 10 parts by mass or more based on 100 parts by mass of the component (A).
[2] The photosensitive resin composition as set forth in the above [1], wherein the photopolymerizable compound (A) having an ethylenically unsaturated group further includes at least one selected from the group consisting of (Ai) a monofunctional vinyl monomer having one polymerizable ethylenically unsaturated group, (Aii) a bifunctional vinyl monomer having two polymerizable ethylenically unsaturated groups, and (Aiii) a polyfunctional vinyl monomer having at least three polymerizable ethylenically unsaturated groups.
[3] The photosensitive resin composition as set forth in the above [1] or [2], wherein in both the photopolymerizable compound (A1) having an acidic substituent and an alicyclic structure together with an ethylenically unsaturated group and the thermosetting resin (C1) having an alicyclic structure, the alicyclic structure is an alicyclic structure having a ring-forming carbon number of 5 to 20.
[4] The photosensitive resin composition as set forth in the above [1] or [2], wherein in both the photopolymerizable compound (A1) having an acidic substituent and an alicyclic structure together with an ethylenically unsaturated group and the thermosetting resin (C1) having an alicyclic structure, the alicyclic structure is composed of two or more rings.
[5] The photosensitive resin composition as set forth in the above [1], [2], or [4], wherein in both the photopolymerizable compound (A1) having an acidic substituent and an alicyclic structure together with an ethylenically unsaturated group and the thermosetting resin (C1) having an alicyclic structure, the alicyclic structure is composed of three rings.
[6] The photosensitive resin composition as set forth in any of the above [1] to [5], wherein in both the photopolymerizable compound (A1) having an acidic substituent and an alicyclic structure together with an ethylenically unsaturated group and the thermosetting resin (C1) having an alicyclic structure, the alicyclic structure is represented by the following general formula (a): 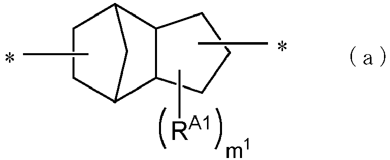 wherein R^{A1} represents an alkyl group having 1 to 12 carbon atoms and may be substituted in any site in the alicyclic structure; m¹ is an integer of 0 to 6; and * is a binding site to other structure.
[7] The photosensitive resin composition as set forth in any of the above [1] to [6], wherein the photopolymerizable compound (A1) having an acidic substituent and an alicyclic structure together with an ethylenically unsaturated group is represented by the following general formula (A-1): 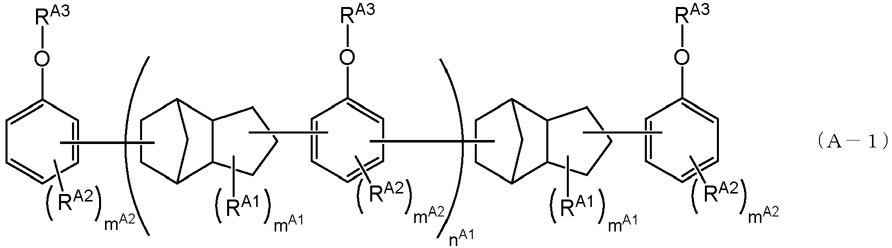 wherein R^{A1} represents an alkyl group having 1 to 12 carbon atoms and may be substituted in any site in the alicyclic structure; R^{A2} represents an alkyl group having 1 to 12 carbon atoms; R^{A3} is an organic group having an ethylenically unsaturated group, an organic group having an ethylenically unsaturated group and an acidic substituent, or a glycidyl group, and at least one R^{A3} is an organic group having an ethylenically unsaturated group and an acidic substituent; m^{A1} is an integer of 0 to 6; m^{A2} is an integer of 0 to 3; and n^{A1} is 0 to 10.
[8] The photosensitive resin composition as set forth in any of the above [1] to [7], wherein in the photopolymerizable compound (A1) having an acidic substituent and an alicyclic structure together with an ethylenically unsaturated group, the acidic substituent is at least one selected from the group consisting of a carboxy group, a sulfonic acid group, and a phenolic hydroxy group.
[9] The photosensitive resin composition as set forth in any of the above [1] to [8], wherein the thermosetting rein (C1) having an alicyclic structure is represented by the following general formula (C-1): 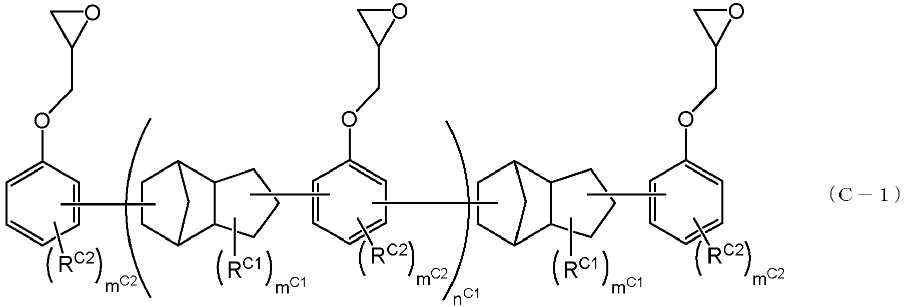 wherein R^{C1} represents an alkyl group having 1 to 12 carbon atoms and may be substituted in any site in the alicyclic structure; R^{C2} represents an alkyl group having 1 to 12 carbon atoms; m^{C1} is an integer of 0 to 6; m^{C2} is an integer of 0 to 3; and n^{C1} is 0 to 10.
[10] The photosensitive resin composition as set forth in any of the above [1] to [9], further containing (F) an inorganic filler.
[11] The photosensitive resin composition as set forth in any of the above [1] to [10], further containing (G) a curing agent.
[12] A photosensitive resin composition for photo via formation, including the photosensitive resin composition as set forth in any of the above [1] to [11].
[13] A photosensitive resin composition for interlayer insulating layer, including the photosensitive resin composition as set forth in any of the above [1] to [11].
[14] A photosensitive resin film including the photosensitive resin composition as set forth in any of the above [1] to [11].
[15] A photosensitive resin film for interlayer insulating layer, including the photosensitive resin composition as set forth in any of the above [1] to [11].
[16] A multilayer printed wiring board including an interlayer insulating layer formed of the photosensitive resin composition as set forth in any of the above [1] to [11].
[17] A multilayer printed wiring board including an interlayer insulating layer formed of the photosensitive resin film as set forth in the above [14].
[18] A semiconductor package including the multilayer printed wiring board as set forth in the above [16] or [17] having a semiconductor element mounted thereon.
[19] A method for producing a multilayer printed wiring board, including the following steps (1) to (4):
   Step (1): a step of laminating the photosensitive resin film as set forth in the above [14] on one surface or both surfaces of a circuit substrate;
   Step (2): a step of exposing and developing the photosensitive resin film laminated in the step (1), to form an interlayer insulating layer having a via;
   Step (3): a step of subjecting the via and the interlayer insulating layer to a roughening treatment; and
   Step (4): a step of forming a circuit pattern on the interlayer insulating layer.

### Advantageous Effects of Invention

In accordance with the present invention, it is possible to provide a photosensitive resin composition, a photosensitive resin composition for photo via formation, and a photosensitive resin composition for interlayer insulating layer, each of which is excellent in photosensitive characteristics and stripp ability from a support film. In addition, it is also possible to provide a photosensitive resin film and a photosensitive resin film for interlayer insulating layer, each of which is composed of the aforementioned photosensitive resin composition and to provide a multilayer printed wiring board and a semiconductor package, each of which contains an interlayer insulating layer formed of the aforementioned photosensitive resin composition or the aforementioned photosensitive resin film.

Furthermore, it is possible to provide a method for efficiently producing a multilayer printed wiring board having a via with a high resolution. The via which the multilayer printed wiring board obtained in the production method of the present invention has is able to be made smaller in diameter than a via formed by means of laser processing.

### Brief Description of Drawing

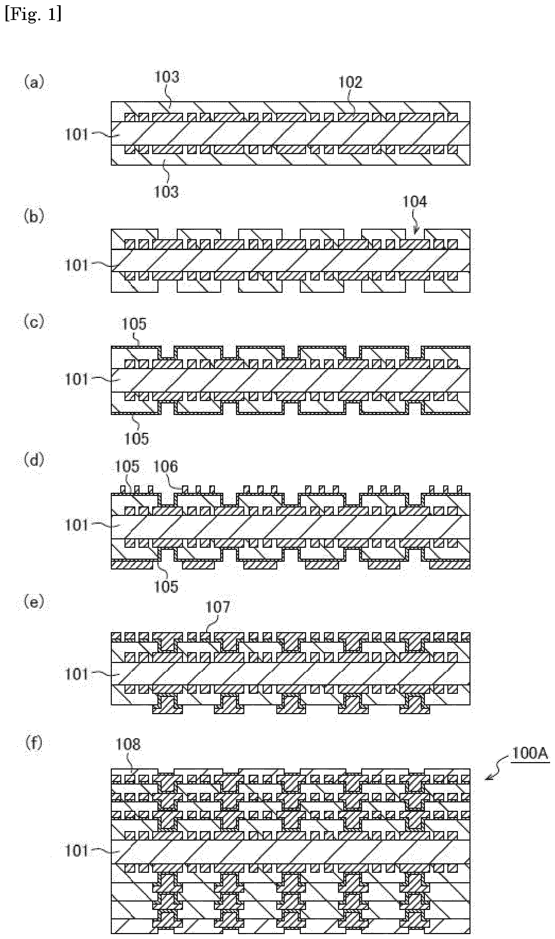

Fig. 1 is a schematic view showing an embodiment of the production process of the multilayer printed wiring board of the present embodiment.

### Description of Embodiments

In numerical value ranges described in this specification, an upper limit value or a lower limit value in a respective numerical value range may be substituted by a value described in the section of Examples. In addition, the lower limit value and the upper limit value of the numerical value range are each arbitrarily combined with a lower limit value or an upper limit value of other numerical value range.

Furthermore, in this specification, as for the content of a respective component in the photosensitive resin composition, in the case where plural kinds of substances corresponding to the respective component exist, it means a total content of the plural kinds of substances existing in the photosensitive resin composition unless otherwise indicated.

The term "ring-forming carbon number" as referred to in this specification is the number of carbon atoms necessary for forming the ring, but the number of carbon atoms of a substituent (for example, a methyl group) which the ring has is not included. For example, in all of a cyclohexane structure and a methylcyclohexane structure, the ring-forming carbon number is 6.

Embodiments of any combination of the matters described in this specification are also included in the present invention.

### [Photosensitive Resin Composition, Photosensitive Resin Composition for Photo via Formation, and Photosensitive Resin Composition for Interlayer Insulating Layer]

The photosensitive resin composition according to an embodiment of the present invention (hereinafter occasionally referred to simply as "present embodiment") is a photosensitive resin composition containing (A) a photopolymerizable compound having an ethylenically unsaturated group, (B) a photopolymerization initiator, and (C) a thermosetting resin, wherein the photopolymerizable compound (A) having an ethylenically unsaturated group includes (A1) a photopolymerizable compound having an acidic substituent and an alicyclic structure together with an ethylenically unsaturated group; and further, the thermosetting resin (C) includes (C1) a thermosetting resin having an alicyclic structure, and the content of the component (C1) is 10 parts by mass or more based on 100 parts by mass of the component (A).

In this specification, the aforementioned components are occasionally referred to as the component (A), the component (B), the component (A1), the component (C), and so on, and other components are also occasionally referred in the same way. In this specification, the "resin components" are the aforementioned components (A) to (C) and so on, and other components which may be contained, if desired (for example, components (C), (E), and (H)) are included. However, an inorganic filler (F) and a pigment (G) as mentioned later, which may be contained, if desired, are not included. In addition, the "solid component" means a nonvolatile component contained in the photosensitive resin composition, exclusive of a volatile substance, such as water and a solvent, and refers to a component which during drying the resin composition, remains without being volatilized, and it also includes those which are in a liquid state, a starch syrup-like state, or a waxy state at room temperature in the vicinity of 25°C.

Since the photosensitive resin composition of the present embodiment is suited for via formation by means of photolithography (hereinafter referred to as "photo via formation"), the present invention also provides a photosensitive resin composition for photo via formation. In addition, since the photosensitive resin composition of the present embodiment is excellent in both photosensitive characteristics and strippability from a support film and further, is excellent in electrical insulation reliability and is useful as an interlayer insulating layer of a multilayer printed wiring board, the present invention also provides a photosensitive resin composition for interlayer insulating layer. In the case where the photosensitive resin composition is referred to in this specification, a photosensitive resin composition for photo via formation and a photosensitive resin composition for interlayer insulating layer are also included.

The photosensitive resin composition of the present embodiment is useful as a negative working-type photosensitive resin composition.

The respective components which can be contained in the photosensitive resin composition are hereunder described in detail.

### <(A) Photopolymerizable Compound Having Ethylenically Unsaturated Group>

The photosensitive resin composition of the present embodiment includes a photopolymerizable compound having an ethylenically unsaturated group as the component (A). Examples of the ethylenically unsaturated group which the component (A) has include a vinyl group, an allyl group, a propargyl group, a butenyl group, an ethynyl group, a phenylethynyl group, a maleimide group, a nadimide group, and a (meth)acryloyl group. The ethylenically unsaturated group is preferably a (meth)acryloyl group.

In the present invention, the component (A) includes (A1) a photopolymerizable compound having an acidic substituent group and an alicyclic structure together with an ethylenically unsaturated group as mentioned later. In order that both the photosensitive characteristics and the strippability from a support film may be made compatible with each other, it is important that the component (A) includes at least the component (A1).

The component (A1) is hereunder described in detail.

### ((A1) Photopolymerizable Compound Having Acidic Substituent and Alicyclic Structure together with Ethylenically Unsaturated Group)

Examples of the ethylenically unsaturated group which the component (A1) has include the same groups as those for the ethylenically unsaturated group as mentioned above. At least one selected from group consisting of a vinyl group, an allyl group, a propargyl group, a butenyl group, an ethynyl group, a phenylethynyl group, a maleimide group, a nadimide group, and a (meth)acryloyl group is preferred; a vinyl group, an allyl group, and a (meth)acryloyl group are more preferred; and a (meth)acryloyl group is still more preferred.

As the acidic substituent which the component (A1) has, at least one selected from the group consisting of a carboxy group, a sulfonic acid group, a phenolic hydroxy group, and so on is preferred, and a carboxy group is more preferred.

From the viewpoint of photosensitive characteristics and strippability from a support film, the alicyclic structure which the component (A1) has is preferably an alicyclic structure having a ring-forming carbon number of 5 to 20, more preferably an alicyclic structure having a ring-forming carbon number of 5 to 18, still more preferably an alicyclic structure having a ring-forming carbon number of 6 to 18, especially preferably an alicyclic structure having a ring-forming carbon number of 8 to 14, and most preferably an alicyclic structure having a ring-forming carbon number of 8 to 12.

From the viewpoint of photosensitive characteristics and strippability from a support film, the aforementioned alicyclic structure is preferably composed of 2 or more rings, more preferably composed of 2 to 4 rings, and still more preferably composed of 3 rings. Examples of the alicyclic structure composed of 2 or more rings include a norbornane structure, a decalin structure, a bicycloundecane structure, and a saturated dicyclopentadiene structure.

From the viewpoint of photosensitive characteristics and strippability from a support film, the aforementioned alicyclic structure is preferably a saturated dicyclopentadiene structure, and more preferably a saturated alicyclic structure (saturated dicyclopentadiene structure) represented by the following general formula (a).

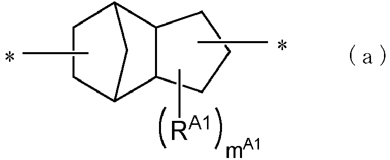

In the general formula (a), R^{A1} represents an alkyl group having 1 to 12 carbon atoms and may be substituted in any site in the alicyclic structure; m^{A1} is an integer of 0 to 6; and * is a binding site to other structure.

In the general formula (a), examples of the alkyl group having 1 to 12 carbon atoms, which is represented by R^{A1}, include a methyl group, an ethyl group, a n-propyl group, an isopropyl group, a n-butyl group, an isobutyl group, a t-butyl group, and a n-pentyl group. The alkyl group is preferably an alkyl group having 1 to 6 carbon atoms, more preferably an alkyl group having 1 to 3 carbon atoms, and still more preferably a methyl group.
m^{A1} is an integer of 0 to 6, preferably an integer of 0 to 5, more preferably an integer of 0 to 2, and still more preferably 0.

In the case where m^{A1} is 2 or more, plural R^{A1'}s may be the same as or different from each other. Furthermore, plural R^{A1'}s may be substituted on the same carbon atom within a possible range or may be substituted on a different carbon atom from each other.
* is a binding site to other structure, and binding may be made by any carbon atom on the alicyclic structure; however, binding is preferably made by the carbon atom expressed by 1 or 2 and the carbon atom expressed by 3 to 4 in the following general formula (a').

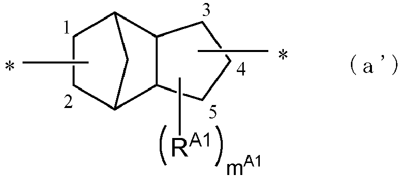

In the general formula (a'), R^{A1}, m^{A1}, and * are the same as those in the general formula (a).

The component (A1) is preferably "(A1-1) an acid-modified ethylenically unsaturated group and alicyclic structure-containing epoxy derivative" which is obtained by allowing a compound resulting from modifying (a1) an alicyclic structure-containing epoxy resin with (a2) an ethylenically unsaturated group-containing organic acid [the foregoing compound will be hereinafter occasionally referred to as "component (A')"] to react with (a3) a saturated group or unsaturated group-containing polybasic acid anhydride, from the viewpoint that it is possible to be subjected to alkaline development and the viewpoint of photosensitive characteristics and strippability from a support film.

### - (a1) Alicyclic Structure-Containing Epoxy Resin -

The alicyclic structure-containing epoxy resin (a1) is preferably an epoxy resin having two or more epoxy groups. The epoxy resin is classified into a glycidyl ether type epoxy resin, a glycidyl amine type epoxy resin, a glycidyl ester type epoxy resin, and so on. Of these, a glycidyl ether type epoxy resin is preferred.

In the present invention, at least an alicyclic structure-containing epoxy resin is used as the epoxy resin. The alicyclic structure is explained in the same manner as in the alicyclic structure which the aforementioned component (A1) has, and a preferred embodiment thereof is also the same.

The alicyclic structure-containing epoxy resin (a1) is preferably an epoxy resin represented by the following general formula (a1-1). In addition, an epoxy resin having a structural unit represented by the following general formula (a1-2) is also preferred.

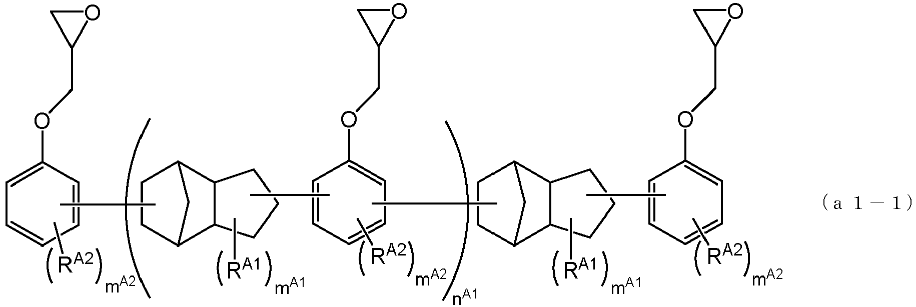

In the general formula (a1-1), R^{A1} represents an alkyl group having 1 to 12 carbon atoms and may be substituted in any site in the alicyclic structure; R^{A2} represents an alkyl group having 1 to 12 carbon atoms; m^{A1} is an integer of 0 to 6; m^{A2} is an integer of 0 to 3; and n^{A1} is 0 to 10.

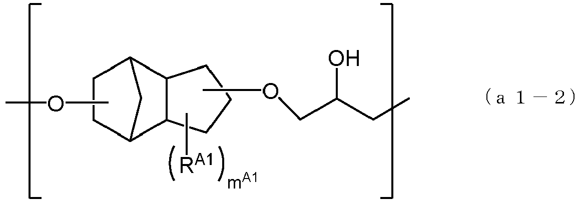

In the general formula (a1-2), R^{A1} represents an alkyl group having 1 to 12 carbon atoms and may be substituted in any site in the alicyclic structure; and m^{A1} is an integer of 0 to 6.

In the general formula (a1-1) and the general formula (a1-2), R^{A1} is the same as R^{A1} in the general formula (a), and a preferred embodiment thereof is also the same.

Examples of the alkyl group having 1 to 12 carbon atoms, which is represented by R^{A1} in the general formula (a1-1), include a methyl group, an ethyl group, a n-propyl group, an isopropyl group, a n-butyl group, an isobutyl group, a t-butyl group, and a n-pentyl group. The alkyl group is preferably an alkyl group having 1 to 6 carbon atoms, more preferably an alkyl group having 1 to 3 carbon atoms, and still more preferably a methyl group.
m^{A1} in the general formula (a1-1) and the general formula (a1-2) is the same as m^{A1} in the general formula (a), and a preferred embodiment thereof is also the same.
m^{A2} in the general formula (a1-1) is an integer of 0 to 3, preferably 0 or 1, and more preferably 0.
n^{A1} in the general formula (a1-1) represents a repeating number of the structural unit within the parenthesis and is 0 to 10. In general, since the epoxy resin is a mixture of compounds having a different repeating number of the structural unit within the parenthesis from each other, in that case, n^{A1} is represented by an average value of the mixture. n^{A1} is preferably 2 to 10.

As the alicyclic structure-containing epoxy resin (a1), a commercially available product may be used. Examples of the commercially available product include XD-1000 (a trade name, manufactured by Nippon Kayaku Co., Ltd.); and EPICLON HP-7200L, EPICLON HP-7200, EPICLON HP-7200HH, and EPICLON HP-7200HHH (trade names, manufactured by DIC Corporation; "EPICLON" is a registered trademark).

As the epoxy resin (a1), other epoxy resin than the aforementioned epoxy resin having an alicyclic structure (hereinafter occasionally referred to as "other epoxy resin") may be used jointly. Examples of the other epoxy resin include bisphenol-based epoxy resins, such as a bisphenol A type epoxy resin, a bisphenol F type epoxy resin, and a bisphenol S type epoxy resin; bisphenol-based novolak type epoxy resins, such as a bisphenol A novolak type epoxy resin and a bisphenol F novolak type epoxy resin; novolak type epoxy resins other than the aforementioned bisphenol-based novolak type epoxy resins, such as a phenol novolak type epoxy resin, a cresol novolak type epoxy resin, and a biphenyl novolak type epoxy resin; phenol aralkyl type epoxy resins; biphenyl aralkyl type epoxy resins; stilbene type epoxy resins; naphthalene structure-containing type epoxy resins, such as a naphthalene type epoxy resin, a naphthol novolak type epoxy resin, a naphthol type epoxy resin, a naphthol aralkyl type epoxy resin, and a naphthylene ether type epoxy resin; biphenyl type epoxy resins; xylylene type epoxy resins; dihydroanthracene type epoxy resins; aliphatic chain epoxy resins; and rubber-modified epoxy resins.

### - (a2) Ethylenically Unsaturated Group-Containing Organic Acid -

Although the ethylenically unsaturated group-containing organic acid (a2) is not particularly restricted, it is preferably an ethylenically unsaturated group-containing monocarboxylic acid. The ethylenically unsaturated group is the same as the ethylenically unsaturated group described above for the component (A1).

Examples of the ethylenically unsaturated group-containing monocarboxylic acid include acrylic acid; acrylic acid derivatives, such as a dimer of acrylic acid, methacrylic acid, β-furfurylacrylic acid, β-styrylacrylic acid, cinnamic acid, crotonic acid, and α-cyanocinnamic acid; half ester compounds that are a reaction product between a hydroxy group-containing acrylate and a dibasic acid anhydride; and half ester compounds that are a reaction product between an ethylenically unsaturated group-containing monoglycidyl ether or an ethylenically unsaturated group-containing monoglycidyl ester and a dibasic acid anhydride. Of these, acrylic acid is preferred.

The component (a2) may be used alone or may be used in combination of two or more thereof.

The aforementioned half ester compound is, for example, obtained by allowing a hydroxy group-containing acrylate, an ethylenically unsaturated group-containing monoglycidyl ether, or an ethylenically unsaturated group-containing monoglycidyl ester to react with a dibasic acid anhydride in an equimolar ratio.

Examples of the hydroxy group-containing acrylate, the ethylenically unsaturated group-containing monoglycidyl ether, and the ethylenically unsaturated group-containing monoglycidyl ester, each of which is used for synthesis of the aforementioned half ester compound that is an example of the component (a2), include hydroxyethyl acrylate, hydroxyethyl methacrylate, hydroxypropyl acrylate, hydroxypropyl methacrylate, hydroxybutyl acrylate, hydroxybutyl methacrylate, polyethylene glycol monoacrylate, polyethylene glycol monomethacrylate, trimethylolpropane diacrylate, trimethylolpropane dimethacrylate, pentaerythritol triacrylate, pentaerythritol trimethacrylate, dipentaerythritol pentaacrylate, pentaerythritol pentamethacrylate, glycidyl acrylate, and glycidyl dimethacrylate.

The dibasic acid anhydride which is used for synthesis of the aforementioned half ester compound may be ether one containing a saturated group or one containing an unsaturated group. Examples of the dibasic acid anhydride include succinic anhydride, maleic anhydride, tetrahydrophthalic anhydride, phthalic anhydride, methyltetrahydrophthalic anhydride, ethyltetrahydrophthalic anhydride, hexahydrophthalic anhydride, methylhexahydrophthalic anhydride, ethylhexahydrophthalic anhydride, and itaconic anhydride.

Although there is no particular limitation, in the reaction between the component (a1) and the component (a2), it is preferred to perform the reaction in a ratio such that the component (a2) is 0.6 to 1.05 equivalents relative to 1 equivalent of the epoxy group of the component (a1), and the reaction may be performed such that the foregoing ratio is 0.8 to 1.0 equivalent. By performing the reaction in such a ratio, there is a tendency that the photopolymerizability is improved, namely the photosensitivity becomes large, and the photosensitive characteristics, particularly resolution of via are improved.

The component (a1) and the component (a2) can be reacted upon being dissolved in an organic solvent.

Examples of the organic solvent include ketones, such as methyl ethyl ketone and cyclohexanone; aromatic hydrocarbons, such as toluene, xylene, and tetramethylbenzene; glycol ethers, such as methyl cellosolve, butyl cellosolve, methyl carbitol, butyl carbitol, propylene glycol monomethyl ether, dipropylene glycol monoethyl ether, dipropylene glycol diethyl ether, and triethylene glycol monoethyl ether; esters, such as ethyl acetate, butyl acetate, butyl cellosolve acetate, and carbitol acetate; aliphatic hydrocarbons, such as octane and decane; and petroleum-based solvents, such as petroleum ether, petroleum naphtha, hydrogenated petroleum naphtha, and solvent naphtha.

Furthermore, in order to promote the reaction between the component (a1) and the component (a2), it is preferred to use a catalyst. Examples of the catalyst include amine-based catalysts, such as triethylamine and benzyl methylamine; quaternary ammonium salt catalysts, such as methyltriethylammonium chloride, benzyltrimethylammonium chloride, benzyltrimethylammonium bromide, and benzyltrimethylammonium iodide; and phosphine-based catalysts, such as triphenyl phosphine. Of these, phosphine-based catalysts are preferred, and triphenyl phosphine is more preferred.

The use amount of the catalyst is preferably 0.01 to 10 parts by mass, more preferably 0.05 to 5 parts by mass, and still more preferably 0.1 to 2 parts by mass based on 100 parts by mass of the total of the component (a1) and the component (a2). When the aforementioned use amount falls within the aforementioned range, there is a tendency that the reaction between the component (a1) and the component (a2) is promoted.

For the purpose of preventing polymerization during the reaction from occurring, it is preferred to use a polymerization inhibitor. Examples of the polymerization inhibitor include hydroquinone, methyl hydroquinone, hydroquinone monomethyl ether, catechol, and pyrogallol.

In the case of using the polymerization inhibitor, from the viewpoint of improving the storage stability of the composition, the use amount thereof is preferably 0.01 to 1 part by mass, more preferably 0.02 to 0.8 parts by mass, and still more preferably 0.05 to 0.5 parts by mass based on 100 parts by mass of the total of the component (a1) and the component (a2).

From the viewpoint of productivity, a reaction temperature between the component (a1) and the component (a2) is preferably 60 to 150°C, more preferably 70 to 120°C, and still more preferably 80 to 120°C.

In the light of the above, it may be conjectured that the component (A') which is obtained by allowing the component (a1) and the component (A2) to react with each other is one having a hydroxy group formed through a ring-opening addition reaction between the epoxy group of the component (a1) and the carboxy group of the component (a2).

### - (a3) Polybasic Acid Anhydride -

The component (a3) may be one containing a saturated group or may be one containing an unsaturated group. Examples of the component (a3) include succinic anhydride, maleic anhydride, tetrahydrophthalic anhydride, phthalic anhydride, methyltetrahydrophthalic anhydride, ethyltetrahydrophthalic anhydride, hexahydrophthalic anhydride, methylhexahydrophthalic anhydride, ethylhexahydrophthalic anhydride, and itaconic anhydride. Of these, tetrahydrophthalic anhydride is preferred from the viewpoint of photosensitive characteristics.

It may be conjectured that by further allowing the above-obtained component (A') to react with the component (a3) containing a saturated or unsaturated group, the acid-modified ethylenically unsaturated group and alicyclic structure-containing epoxy derivative (A1-1) in which the hydroxy group of the component (A') (also including the hydoxy group originally existing in the component (a1)) and the acid anhydride group of the component (a3) are half-esterified is formed.

In the reaction between the component (A') and the component (a3), for example, by reacting 0.1 to 1.0 equivalent of the compound (a3) relative to one equivalent of the hydroxy group in the component (A'), the acid value of the acid-modified ethylenically unsaturated group and alicyclic structure-containing epoxy derivative (A1-1) can be controlled.

The acid value of the acid-modified ethylenically unsaturated group and alicyclic structure-containing epoxy derivative (A1-1) is preferably 30 to 150 mgKOH/g, more preferably 40 to 120 mgKOH/g, and still more preferably 50 to 100 mgKOH/g. When the acid value is 30 mgKOH/g or more, there is a tendency that the solubility of the photosensitive resin composition in a dilute alkaline solution becomes excellent, and when it is 150 mgKOH/g or less, there is a tendency that the electric characteristics of the cured film are improved.

From the viewpoint of productivity, a reaction temperature between the component (A') and the component (a3) is preferably 50 to 150°C, more preferably 60 to 120°C, and still more preferably 70 to 100°C.

In the light of the above, though the photopolymerizable compound (A1) having an acidic substituent and an alicyclic structure together with an ethylenically unsaturated group is not particularly restricted, it is preferably represented by the following general formula (A-1).

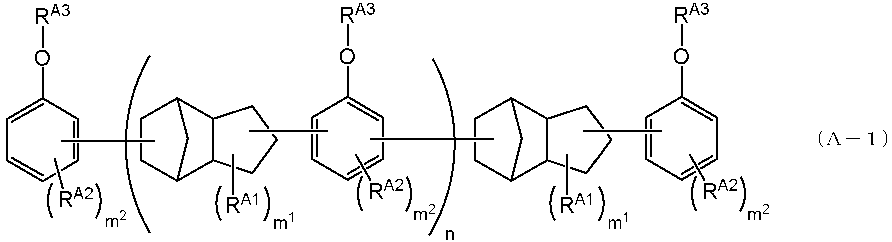

In the general formula (A-1), R^{A1} represents an alkyl group having 1 to 12 carbon atoms and may be substituted in any site in the alicyclic structure; R^{A2} represents an alkyl group having 1 to 12 carbon atoms; R^{A3} is an organic group having an ethylenically unsaturated group, an organic group having an ethylenically unsaturated group and an acidic substituent, or a glycidyl group, and at least one R^{A3} is an organic group having an ethylenically unsaturated group and an acidic substituent; m^{A1} is an integer of 0 to 6; m^{A2} is an integer of 0 to 3; and n^{A1} is 0 to 10.

In the general formula (A-1), R^{A1}, R^{A2}, m^{A1}, m^{A2}, and n^{A1} are the same as those in the general formula (a1-1), and preferred embodiments thereof are also the same.

Although R^{A3} is the same as defined above, the glycidyl group in the general formula (a1-1) is corresponding to the site formed through the reaction between the component (a2) and the component (a3) and is defined taking into consideration the matter that a part of the glycidyl group is unreacted. Namely, the "organic group having an ethylenically unsaturated group" that is a choice for R^{A3} is a group derived from the component (a2); the "organic group having an ethylenically unsaturated group and an acidic substituent" is a group derived from the components (a2) and (a3); and when the components (a2) and (a3) react with all of the glycidyl groups in the general formula (a1-1), R^{A3} becomes the "organic group having an ethylenically unsaturated group and an acidic substituent", whereas the site which reacts with only the component (a2) becomes the "organic group having an ethylenically unsaturated group", and the site which does not react with any of the components (a2) and (a3) becomes the "glycidyl group".

### ((A1) Molecular Weight of Photopolymerizable Compound Having Acidic Substituent and Alicyclic Structure together with Ethylenically Unsaturated Group)

A weight average molecular weight (Mw) of the component (A1) is preferably 1,000 to 30,000, more preferably 2,000 to 25,000, and still more preferably 3,000 to 18,000. When the foregoing weight average molecular weight falls within the aforementioned range, the photosensitive characteristics and the strippability from a support film are improved. In particular, it is preferred that the weight average molecular weight (Mw) of the acid-modified ethylenically unsaturated group and alicyclic structure-containing epoxy derivative (A1-1) falls within the aforementioned range. Here, in this specification, the weight average molecular weight is a value measured using a calibration curve of standard polystyrene with a gel permeation chromatograph (GPC) (manufactured by Tosoh Corporation), and in more detail, it is a value measured according to a method described below.

### <Measurement Method of Weight Average Molecular Weight>

As for the weight average molecular weight, a value obtained by performing the measurement using a GPC measurement apparatus as mentioned below and under a measurement condition as also mentioned below and converting the measured value using a calibration curve of standard polystyrene was defined as the weight average molecular weight. In addition, for preparing the calibration curve, 5 sample sets of standard polystyrene ("PStQuick MP-H" and "PStQuick B", manufactured by Tosoh Corporation) were used.

### (GPC Measurement Apparatus)

GPC device: High-speed GPC device "HCL-8320GPC", with a differential refractometer or UV as the detector, manufactured by Tosoh Corporation Column: Column TSKgel SuperMultipore HZ-H (column length: 15 cm, column inner diameter: 4.6 mm), manufactured by Tosoh Corporation

### (Measurement Condition)

Solvent: Tetrahydrofuran (THF)
Measurement temperature: 40°C
Flow rate: 0.35 mL/min
Sample concentration: 10 mg/5 mL of THF
Injection volume: 20 µL

### ((A2-1) Acid-Modified Ethylenically Unsaturated Group-Containing Epoxy Derivative Not Containing Alicyclic Structure)

The photopolymerizable compound (A) having an ethylenically unsaturated group may be an embodiment further including "(A2-1) an acid-modified ethylenically unsaturated group-containing epoxy derivative not containing an alicyclic structure" which is obtained by allowing a compound resulting from modifying (a21) an epoxy resin (not containing an alicyclic structure) with (a22) an ethylenically unsaturated group-containing organic acid to react with (a23) a saturated group or unsaturated group-containing polybasic acid anhydride, or may also be an embodiment not including the component (A2-1).

The epoxy resin (a21) is not particularly restricted so long as it is an epoxy resin not containing an alicyclic structure, and examples thereof include a glycidyl ether type epoxy resin, a glycidyl amine type epoxy resin, and a glycidyl ester type epoxy resin. Of these, a glycidyl ether type epoxy resin is preferred.

The epoxy resin (a21) is classified into various epoxy resins depending upon a difference of the main structure, and in the aforementioned epoxy resins of respective types, the epoxy resin is further classified as follows. Specifically, the epoxy resin is classified into bisphenol-based epoxy resins, such as a bisphenol A type epoxy resin, a bisphenol F type epoxy resin, and a bisphenol S type epoxy resin; bisphenol-based novolak type epoxy resins, such as a bisphenol A novolak type epoxy resin and a bisphenol F novolak type epoxy resin; novolak type epoxy resins other than the aforementioned bisphenol-based novolak type epoxy resins, such as a phenol novolak type epoxy resin, a cresol novolak type epoxy resin, and a biphenyl novolak type epoxy resin; phenol aralkyl type epoxy resins; stilbene type epoxy resins; naphthalene structure-containing type epoxy resins, such as a naphthalene type epoxy resin, a naphthol novolak type epoxy resin, a naphthol type epoxy resin, a naphthol aralkyl type epoxy resin, and a naphthylene ether type epoxy resin; biphenyl type epoxy resins; biphenyl aralkyl type epoxy resins; xylylene type epoxy resins; dihydroanthracene type epoxy resins; aliphatic chain epoxy resins; rubber-modified epoxy resins; and so on.

The ethylenically unsaturated organic acid (a22) and the saturated group or unsaturated group-containing polybasic acid anhydride (a23) are the same as those described above for the ethylenically unsaturated group-containing organic acid (a2) and the saturated group or unsaturated group-containing polybasic acid anhydride (a3), and preferred embodiments thereof are also the same.

As a method for allowing the compound resulting from modifying the component (a21) with the component (a22) to react with the component (a23), the method for allowing the compound resulting from modifying the component (a1) with the component (a2) to react with the component (a3) can be made by reference.

As the acid-modified ethylenically unsaturated group-containing epoxy derivative (A2-1) not containing an alicyclic structure, a commercially available product may be used. Examples of the commercially available product include CCR-1218H, CCR-1159H, CCR-1222H, PCR-1050, TCR-1335H, ZAR-1035, ZAR-2001H, UXE-3024, ZFR-1185, ZCR-1569H, ZXR-1807, ZCR-6000, and ZCR-8000 (trade names, manufactured by Nippon Kayaku Co., Ltd.); and UE-9000, UE-EXR-2810PM, and UE-EXP-3045 (trade names, manufactured by DIC Corporation).

### ((A2-2) Styrene-Maleic Acid-based Resin)

As the photopolymerizable compound (A) having an ethylenically unsaturated group, "(A2-2) a styrene-maleic acid-based resin", such as a hydroxyethyl (meth)acrylate modified product of a styrene-maleic anhydride copolymer, can also be used jointly. The component (A2-2) does not contain an alicyclic structure. The component (A2-2) may be used alone or may be used in combination of two or more thereof.

### ((A2-3) Epoxy-based Polyurethane Resin)

As the polymerizable compound (A) having an ethylenically unsaturated group, "(A2-3) an epoxy-based polyurethane resin" which is obtained by allowing a compound resulting from modifying the epoxy resin (a21) with the ethylenically unsaturated group-containing organic acid (a22), namely the component (A'), to react with an isocyanate compound can also be used jointly. The component (A2-3) does not contain an alicyclic structure. The component (A2-3) may be used alone or may be used in combination of two or more thereof.

### ((A) Other Component than Those mentioned above)

As for the photopolymerizable compound (A) having an ethylenically unsaturated group, from the viewpoint of enhancing the chemical resistance after curing (exposure) to make a difference in developer resistance between an exposed area and an unexposed area large, the photopolymerizable compound (A) having an ethylenically unsaturated group is preferably an embodiment including at least one selected from the group consisting of (Ai) a monofunctional vinyl monomer having one ethylenically unsaturated group, (Aii) a bifunctional vinyl monomer having two polymerizable ethylenically unsaturated groups, and (Aiii) a polyfunctional vinyl monomer having at least three polymerizable ethylenically unsaturated groups, and more preferably an embodiment including the component (Aiii). The components (Ai) to (Aiii) are preferably ones having a molecular weight of 1,000 or less. However, in the present invention, the components (Ai) to (Aiii) do not include the component (A1).

### ((Ai) Monofunctional Vinyl Monomer)

Examples of the monofunctional vinyl monomer having one polymerizable ethylenically unsaturated group include (meth)acrylic acid and a (meth)acrylic acid alkyl ester. Examples of the (meth)acrylic acid alkyl ester include methyl (meth)acrylate, ethyl (meth)acrylate, butyl (meth)acrylate, 2-ethylhexyl (meth)acrylate, and hydroxyethyl (meth)acrylate. The component (Ai) may be used alone or may be used in combination of two or more thereof.

### ((Aii) Bifunctional Vinyl Monomer)

Examples of the bifunctional vinyl monomer having two polymerizable ethylenically unsaturated groups include polyethylene glycol di(meth)acrylate, trimethylolpropane di(meth)acrylate, polypropylene glycol di(meth)acrylate, 2,2-bis(4-(meth)acryloxypolyethoxypolypropoxyphenyl)propane, and bisphenol A diglycidyl ether di(meth)acrylate. The component (Aii) may be used alone or may be used in combination of two or more thereof.

### ((Aiii) Polyfunctional Vinyl Monomer)

Examples of the polyfunctional vinyl monomer having at least three polymerizable ethylenically unsaturated groups include (meth)acrylate compounds having a trimethylolpropane-derived structure, such as trimethylolpropane tri(meth)acrylate; (meth)acrylate compounds having a tetramethylolmethane-derived structure, such as tetramethylolmethane tri(meth)acrylate and tetramethylolmethane tetra(meth)acrylate; (meth)acrylate compounds having a pentaerythritol-derived structure, such as pentaerythritol tri(meth)acrylate and pentaerythritol tetra(meth)acrylate; (meth)acrylate compounds having a dip entaerythritol-derived structure, such as dipentaerythritol penta(meth)acrylate and dipentaerythritol hexa(meth)acrylate; (meth)acrylate compounds having a ditrimethylolpropane-derived structure, such as ditrimethylolpropane tetra(meth)acrylate; and (meth)acrylate compounds having a diglycerin-derived structure. Of these, from the viewpoint of enhancing the chemical resistance after curing (exposure) to make a difference in developer resistance between an exposed area and an unexposed area large, (meth)acrylate compounds having a dipentaerythritol-derived structure are preferred, and dipentaerythritol penta(meth)acrylate is more preferred. The component (Aiii) may be used alone or may be used in combination of two or more thereof.

Here, the term "(meth)acrylate compound having an XXX-derived structure" ("XXX" is a compound name) means an esterified product between XXX and (meth)acrylic acid, and a compound modified with an alkylene oxy group is also included in the foregoing esterified product.

### (Content of Component (A))

Although the content of the component (A) is not particularly restricted, from the viewpoint of heat resistance, electrical characteristics, and chemical resistance, it is preferably 5 to 80% by mass, more preferably 10 to 75% by mass, still more preferably 25 to 75% by mass, and especially preferably 45 to 70% by mass on the basis of the whole amount of the solid components of the photosensitive resin composition.

Although the component (A) is not particularly restricted, from the viewpoint of photosensitive characteristics, it is preferred to use the component (A1) in combination with the component (Aiii). In this case, a content proportion [(A1)/(Aiii)] (mass ratio) of the component (A1) to the component (Aiii) is preferably 2 to 20, more preferably 4 to 15, still more preferably 6 to 13, especially preferably 8 to 12, and most preferably 8 to 11.

From the viewpoint of photosensitive characteristics, adhesion strength to plated copper, and electrical insulation reliability, a content ratio of the component (A1) to the whole amount of the component (A) is preferably 20 to 95% by mass, more preferably 40 to 90% by mass, still more preferably 45 to 80% by mass, and especially preferably 50 to 70% by mass.

### <(B) Photopolymerization Initiator>

The component (B) which is used in the present embodiment is not particularly restricted so long as it is able to polymerize the component (A), and it can be appropriately selected from typically used photopolymerization initiators.

Examples of the component (B) include benzoins, such as benzoins, benzoin methyl ether, and benzoin isopropyl ether; acetophenones, such as acetophenones, 2,2-dimethoxy-2-phenylacetophenone, 2,2-diethoxy-2-phenylacetophenone, 1,1-dichloroacetophenone, 1-hydroxycyclohexylphenyl ketone, 2-benzyl-2-dimethylamino-1-(4-morpholinophenyl)-1-butanone, 2-methyl-1-[4-(methylthio)phenyl]-2-morpholino-1-propanone, and N,N-dimethylaminoacetophenone; anthraquinones, such as 2-methylanthraquinone, 2-ethylanthraquinone, 2-tert-butylanthraquinone, 1-chloroanthraquinone, 2-amylanthraquinone, and 2-aminoanthraquinone; thioxanthones, such as 2,4-dimethylthioxanthone, 2,4-diethylthioxanthone, 2-chlorothioxanthone, and 2,4-diisopropylthioxanthone; ketals, such as acetophenone dimethyl ketal and benzyldimethyl ketal; benzophenones, such as benzophenone, methylbenzophenone, 4,4'-dichlorobenzophenone, 4,4'-bis(diethylamino)benzophenone, Michler's ketone, and 4-benzoyl-4'-methyldiphenyl sulfide; acridines, such as 9-phenylacridine and 1,7-bis(9,9'-acridinyl)heptane; acyl phosphine oxides, such as bis(2,4,6-trimethylbenzoyl)phenyl phosphine oxide; and oxime esters, such as 1,2-octanedione- 1-[4-(phenylthio)phenyl] -2-(O-benzoyloxime), 1-[9-ethyl-6-(2-methylbenzoyl)-9H-carbazol-3-yl]ethanone 1-(O-acetyloxime), and 1-phenyl-1,2-propanedione-2-[O-ethoxycarbonyl]oxime]. Of these, acetophenones, acyl phosphine oxides, and oxime esters are preferred; and 2-methyl-1-[4-(methylthio)phenyl]-2-morpholino-1-propanone, bis(2,4,6-trimethylbenzoyl)phenyl phosphine oxide, and 1-[9-ethyl-6-(2-methylbenzoyl)-9H-carbazol-3-yl]ethanone 1-(O-acetyloxime) are more preferred. The acetophenones have such an advantage that they are hardly volatilized and hardly generated as an outgas; the acyl phosphine oxides have such an advantage that even the bottom is readily cured; and the oxime esters have such an advantage that the surface is readily cured.

The component (B) may be used alone or may be used in combination of two or more thereof. In the case of using two or more compounds in combination, it is preferred to use the acetophenones, the acyl phosphine oxides, and the oxime esters in combination, and it is more preferred to use 2-methyl-1-[4-(methylthio)phenyl]-2-morpholino-1-propanone, bis(2,4,6-trimethylbenzoyl)phenyl phosphine oxide, and 1-[9-ethyl-6-(2-methylbenzoyl)-9H-carbazol-3-yl]ethanone 1-(O-acetyloxime) in combination.

### (Content of Component (B))

Although the content of the component (B) is not particularly restricted, it is preferably 0.1 to 15% by mass, more preferably 0.15 to 5% by mass, still more preferably 0.2 to 3% by mass, and especially preferably 0.5 to 2% by mass on the basis of the whole amount of the solid components of the photosensitive resin composition. When the content of the component (B) is 0.1% by mass or more, in the interlayer insulating layer to be formed using the photosensitive resin composition, there is a tendency that a fear in which the exposed site eluates during the development is reduced, and when it is 15% by mass or less, there is a tendency that the heat resistance is improved.

### <(B') Photopolymerization Initiator>

The photosensitive resin composition of the present embodiment may contain (B') a photopolymerization initiation aid together with the aforementioned component (B). Examples of the photopolymerization initiation aid (B') include tertiary amines, such as ethyl N,N-dimethylaminobenzoate, isoamyl N,N-dimethylaminobenzoate, pentyl-4-dimethylaminobenzoate, triethylamine, and triethanolamine. The component (B') may be used alone or may be used in combination of two or more thereof.

In the case where the photosensitive resin composition of the present embodiment contains the component (B'), the content thereof is preferably 0.01 to 20% by mass, more preferably 0.2 to 5% by mass, and still more preferably 0.3 to 2% by mass on the basis of the whole amount of the resin components of the photosensitive resin composition. The photosensitive resin composition of the present embodiment may not contain the component (B').

### <(C) Thermosetting Resin>

The photosensitive resin composition of the present embodiment contains a thermosetting resin as the component (C). The thermosetting resin corresponding to the component (A) is not included in the component (C), and in that respect, it may be said that the component (C) is one not having an ethylenically unsaturated group. In addition, a substance of not only satisfying the foregoing requirements but also having an epoxy group is included in the component (C). In view of the fact that the photosensitive resin composition of the present embodiment contains the thermosetting resin (C), in addition to improvements in adhesion strength to plated copper and insulation reliability, there is a tendency that the heat resistance is improved.

In particular, the photosensitive resin composition of the present embodiment includes (C1) a thermosetting resin having an alicyclic structure as the thermosetting resin (C), the content of the component (C1) being 10 parts by mass or more based on 100 parts by mass of the component (A). According to such an embodiment, both the photosensitive characteristics and the strippability from a support film can be made compatible with each other. From the same viewpoint, the content of the component (C1) is preferably 10 to 40 parts by mass, and more preferably 10 to 35 parts by mass, and it may be 13 to 35 parts by mass, may be 15 to 35 parts by mass, or may be 20 to 35 parts by mass based on 100 pats by mass of the component (A).

Similar to the case of the component (A1), from the viewpoint of photosensitive characteristics and strippability from a support film, the alicyclic structure which the component (C1) has is preferably an alicyclic structure having a ring-forming carbon number of 5 to 20, more preferably an alicyclic structure having a ring-forming carbon number of 5 to 18, still more preferably an alicyclic structure having a ring-forming carbon number of 6 to 18, especially preferably an alicyclic structure having a ring-forming carbon number of 8 to 14, and most preferably an alicyclic structure having a ring-forming carbon number of 8 to 12.

Similar to the case of the aforementioned component (A1), from the viewpoint of photosensitive characteristics and strippability from a support film, the aforementioned alicyclic structure is preferably composed of 2 or more rings, more preferably composed of 2 to 4 rings, and still more preferably composed of 3 rings. Examples of the alicyclic structure composed of 2 or more rings include a norbornane structure, a decalin structure, a bicycloundecane structure, and a saturated dicyclopentadiene structure.

From the viewpoint of photosensitive characteristics and strippability from a support film, the aforementioned alicyclic structure is preferably a saturated dicyclopentadiene structure, and more preferably a saturated alicyclic structure (saturated dicyclopentadiene structure) represented by the following general formula (c).

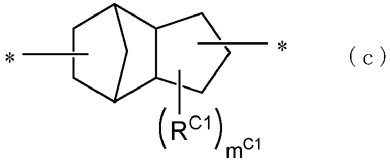

In the general formula (c), R^{C1} represents an alkyl group having 1 to 12 carbon atoms and may be substituted in any site in the alicyclic structure; m^{C1} is an integer of 0 to 6; and * is a binding site to other structure.

In the general formula (c), examples of the alkyl group having 1 to 12 carbon atoms, which is represented by R^{C1}, include a methyl group, an ethyl group, a n-propyl group, an isopropyl group, a n-butyl group, an isobutyl group, a t-butyl group, and a n-pentyl group. The alkyl group is preferably an alkyl group having 1 to 6 carbon atoms, more preferably an alkyl group having 1 to 3 carbon atoms, and still more preferably a methyl group.
m^{C1} is an integer of 0 to 6, preferably an integer of 0 to 5, more preferably an integer of 0 to 2, and still more preferably 0.

In the case where m^{C1} is 2 or more, plural R^{C1'}s may be the same as or different from each other. Furthermore, plural R^{C1'}s may be substituted on the same carbon atom within a possible range or may be substituted on a different carbon atom from each other.
* is a binding site to other structure, and binding may be made by any carbon atom on the alicyclic structure; however, binding is preferably made by the carbon atom expressed by 1 or 2 and the carbon atom expressed by 3 to 4 in the following general formula (c').

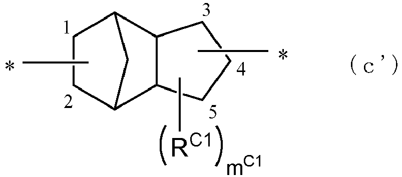

In the general formula (c'), R^{C1}, m^{C1}, and * are the same as those in the general formula (c).

Examples of the thermosetting resin include an epoxy resin, a phenol resin, an unsaturated imide resin, a cyanate resin, an isocyanate resin, a benzoxazine resin, an oxetane resin, an amino resin, an unsaturated polyester resin, an allyl resin, a dicyclopentadiene resin, a silicone resin, a triazine resin, and a melamine resin. In addition, the thermosetting resin is not particularly restricted to these resins, and known thermosetting resins can be used. Of these, an epoxy resin is preferred. Among these, those having an alicyclic structure are classified into the component (C1), and those not having an alicyclic structure are classified into the component (C2).

The component (C) may be used alone or may be used in combination of two or more thereof.

The epoxy resin is preferably an epoxy resin having two or more epoxy groups. The epoxy resin is classified into a glycidyl ether type epoxy resin, a glycidyl amine type epoxy resin, a glycidyl ester type epoxy resin, and so on. Of these, a glycidyl ether type epoxy resin is preferred.

The epoxy resin is classified into various epoxy resins depending upon a difference of the main structure, and in the aforementioned epoxy resins of respective types, the epoxy resin is further classified as follows. Specifically, the epoxy resin is classified into bisphenol-based epoxy resins, such as a bisphenol A type epoxy resin, a bisphenol F type epoxy resin, and a bisphenol S type epoxy resin; bisphenol-based novolak type epoxy resins, such as a bisphenol A novolak type epoxy resin and a bisphenol F novolak type epoxy resin; novolak type epoxy resins other than the aforementioned bisphenol-based novolak type epoxy resins, such as a phenol novolak type epoxy resin, a cresol novolak type epoxy resin, and a biphenyl novolak type epoxy resin; phenol aralkyl type epoxy resins; stilbene type epoxy resins; naphthalene structure-containing type epoxy resins, such as a naphthalene type epoxy resin, a naphthol novolak type epoxy resin, a naphthol type epoxy resin, a naphthol aralkyl type epoxy resin, and a naphthylene ether type epoxy resin; biphenyl type epoxy resins; biphenyl aralkyl type epoxy resins; xylylene type epoxy resins; dihydroanthracene type epoxy resins; alicyclic structure-containing epoxy resins, such as a dicyclopentadiene type epoxy resin; alicyclic epoxy resins; heterocyclic epoxy resins; spiro ring-containing epoxy resins; cyclohexanedimethanol type epoxy resins; trimethylol type epoxy resins; aliphatic chain epoxy resins; rubber-modified epoxy resins; and so on.

The component (C) may be used alone or may be used in combination of two or more thereof.

Of these, as the component (C1), dicyclopentadiene type epoxy resins are preferred from the viewpoint of photosensitive characteristics and strippability from a support film; and as the component (C2), bisphenol-based epoxy resins, naphthol type epoxy resins, naphthalene type epoxy resins, biphenyl type epoxy resins, and naphthylene ether type epoxy resins are preferred, and biphenyl type epoxy resins are more preferred from the viewpoint of heat resistance, electrical insulation reliability, and adhesion strength to plated copper.

As the epoxy resin, commercially available products can be used. Examples thereof include a bisphenol A type epoxy resin (e.g., "jER828EL" and "YL980", manufactured by Mitsubishi Chemical Corporation), a bisphenol F type epoxy resin (e.g., "iER806H" and "YL983U", manufactured by Mitsubishi Chemical Corporation), a naphthalene type epoxy resin (e.g., "HP4032D" and "HP4710", manufactured by DIC Corporation), a naphthalene structure-containing type polyfunctional epoxy resin (e.g., "NC7000", manufactured by Nippon Kayaku Co., Ltd.), a naphthol type epoxy resin (e.g., "ESN-475V", manufactured by NIPPON STEEL Chemical & Material Co., Ltd.), an epoxy resin having a biphenyl structure (e.g., "NC3000H" and "NC3500", manufactured by Nippon Kayaku Co., Ltd., and "YX4000HK" and "YL6121", manufactured by Mitsubishi Chemical Corporation), an anthracene type epoxy resin (e.g., "YX8800", manufactured by Mitsubishi Chemical Corporation), a glycerol type epoxy resin (e.g., "ZX1542", manufactured by NIPPON STEEL Chemical & Material Co., Ltd.), and a naphthylene ether type epoxy resin (e.g., "EXA7311-G4", manufactured by DIC Corporation).

As the component (C1), in particular, an epoxy resin represented by the following general formula (C-1) and an epoxy resin represented by the following general formula (C-2) are preferred, and an epoxy resin represented by the following general formula (C-1) is more preferred.

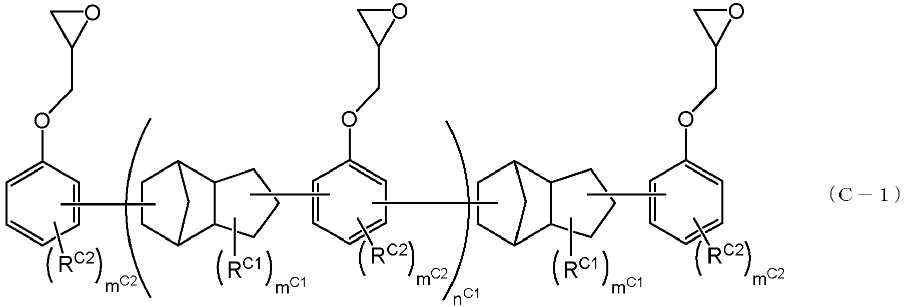

In the general formula (C-1), R^{C1} represents an alkyl group having 1 to 12 carbon atoms and may be substituted in any site in the alicyclic structure; R^{C2} represents an alkyl group having 1 to 12 carbon atoms; m^{C1} is an integer of 0 to 6; m^{C2} is an integer of 0 to 3; and n^{C1} is 0 to 10.

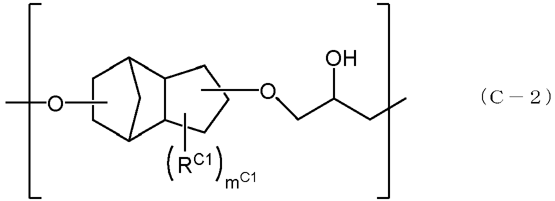

In the general formula (C-2), R^{C1} represents an alkyl group having 1 to 12 carbon atoms and may be substituted in any site in the alicyclic structure; and m^{C1} is an integer of 0 to 6.

In the general formula(C-1) and the general formula (C-2), R^{C1} is the same as R^{C1} in the general formula (c), and a preferred embodiment thereof is also the same.

Examples of the alkyl group having 1 to 12 carbon atoms, which is represented by R^{C2} in the general formula (C-1), include a methyl group, an ethyl group, a n-propyl group, an isopropyl group, a n-butyl group, an isobutyl group, a t-butyl group, and a n-pentyl group. The alkyl group is preferably an alkyl group having 1 to 6 carbon atoms, more preferably an alkyl group having 1 to 3 carbon atoms, and still more preferably a methyl group.
m^{C1} in the general formula (C-1) and the general formula (C-2) is the same as m^{C1} in the general formula (c), and a preferred embodiment thereof is also the same.
m^{C2} in the general formula (C-1) is an integer of 0 to 3, preferably 0 or 1, and more preferably 0.
n^{C1} in the general formula (C-1) represents a repeating number of the structural unit within the parenthesis and is 0 to 10. In general, since the epoxy resin is a mixture of compounds having a different repeating number of the structural unit within the parenthesis from each other, in that case, n^{C1} is represented by an average value of the mixture. n^{C1} is preferably 2 to 10.

As the component (C1), a commercially available product may be used. Examples of the commercially available product include XD-1000 (a trade name, manufactured by Nippon Kayaku Co., Ltd.); and EPICLON HP-7200L, EPICLON HP-7200, EPICLON HP-7200HH, and EPICLON HP-7200HHH (trade names, manufactured by DIC Corporation; "EPICLON" is a registered trademark).

In the case where the photosensitive resin composition of the present embodiment contains the component (C2) together with the component (C1), though a content ratio thereof [{component (C1)}/{component (C2)}] (mass ratio) is not particularly restricted, it is preferably 55/45 to 95/5, more preferably 60/40 to 90/10, still more preferably 70/30 to 90/10, and especially preferably 75/25 to 85/15 from the viewpoint of photosensitive characteristics and strippability from a support film.

Furthermore, besides those exemplified above, an epoxy-modified polybutadiene can be used as the epoxy resin. In particular, as for the component (C), from the viewpoint of handling properties during production of a printed wiring board, an aromatic epoxy resin that is solid at room temperature and an epoxy resin that is liquid at room temperature, such as an epoxy-modified polybutadiene, may be used in combination.

The epoxy-modified polybutadiene is preferably one having a hydroxy group at a molecular terminal, more preferably one having a hydroxy group at both molecular terminals, and still more preferably one having a hydroxy group at only both molecular terminals. In addition, though there is no particular restriction so long as the number of hydroxy group which the epoxy-modified polybutadiene has is 1 or more, it is preferably 1 to 5, more preferably 1 or 2, and still more preferably 2.

From the viewpoint of adhesion strength to plated copper, heat resistance, thermal expansion coefficient, and softness, the epoxy-modified polybutadiene is preferably an epoxy-modified polybutadiene represented by the following general formula (C-3).

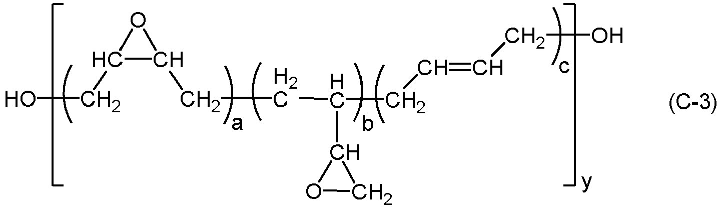

In the formula (C-3), a, b, and c each represent a ratio of the structural unit within the parenthesis; a is 0.05 to 0.40, b is 0.02 to 0.30, and c is 0.30 to 0.80; and a, b, and c are satisfied with not only (a + b + c) = 1.00 but also (a + c) > b; and y represents a number of the structural unit within the parenthesis and is an integer of 10 to 250.

In the general formula (C-3), the binding order of the respective structural units within the parentheses is not in order. Namely, the structural unit expressed in the left, the structural unit expressed in the center, and the structural unit expressed in the right may pass each other, and when they are expressed as (a), (b), and (c), respectively, there may be various binding orders, such as -[(a)-(b)-(c)]-[(a)-(b)-(c)-]-, -[(a)-(c)-(b)]-[(a)-(c)-(b)-]-, -[(b)-(a)-(c)]-[(b)-(a)-(c)-]-, -[(a)-(b)-(c)]-[(c)-(b)-(a)-]-, -[(a)-(b)-(a)]-[(c)-(b)-(c)-]-, and -[(c)-(b)-(c)]-[(b)-(a)-(a)-]-.

From the viewpoint of adhesion strength to plated copper, heat resistance, thermal expansion coefficient, and softness, a is preferably 0.10 to 0.30, b is preferably 0.10 to 0.30, and c is preferably 0.40 to 0.80. In addition, from the same viewpoint, y is preferably an integer of 30 to 180.

In the general formula (C-3), examples of a commercially available product of the epoxidized polybutadiene in which a is 0.20, b is 0.20, c is 0.60, and y is an integer of 10 to 250 include "EPOLEAD (registered trademark) PB3600" (manufactured by Daicel Corporation).

### (Content of Component (C))

Although the content of the component (C) in the photosensitive resin composition of the present embodiment is not particularly restricted, it is preferably 5 to 70% by mass, more preferably 5 to 40% by mass, still more preferably 7 to 30% by mass, and especially preferably 10 to 20% by mass on the basis of the whole amount of the solid components of the photosensitive resin composition. When the content of the component (C) is 5% by mass or more, sufficient crosslinking of the photosensitive resin composition is obtained, and there is a tendency that the adhesion strength to plated copper and the electrical insulation reliability are improved. On the other hand, when it is 70% by mass or less, there is a tendency that the photosensitive characteristics become favorable.

In view of the fact that the component (C) contains the component (C1) in the aforementioned predetermined amount, as mentioned above, both the photosensitive characteristics and the strippability from a support film can be made compatible with each other.

### <(D) Elastomer>

The photosensitive resin composition of the present embodiment may contain an elastomer as the component (D). In view of the fact that the photosensitive resin composition contains the component (D), there is a tendency that a photosensitive resin composition which is excellent in photosensitive characteristics, adhesion strength to plated copper, and electrical insulation reliability is provided. In addition, due to the component (D), there is also brought an effect for inhibiting reduction in flexibility and adhesion strength to plated copper to be caused due to a strain (internal stress) inside the cured product through curing shrinkage of the component (A).

The component (D) is preferably an elastomer that is liquid at 25°C.

The component (D) may be used alone or may be used in combination of two or more thereof.

Examples of the elastomer include an ethylenic elastomer, an olefinic elastomer, a polyester-based elastomer, a urethane-based elastomer, a polyamide-based elastomer, an acrylic elastomer, and a silicone-based elastomer, and it is preferred to use at least one selected from these elastomers. Such an elastomer is composed of a hard segment component and a soft segment component, and there is a tendency that the former contributes to the heat resistance and the strength, whereas there is a tendency that the latter contributes to the softness and the toughness.

Among the above-exemplified elastomers, from the viewpoint of compatibility, solubility, and adhesion strength to plated copper, the component (D) includes preferably at least one selected from the group consisting of an olefinic elastomer, a polyester-based elastomer, and a urethane-based elastomer. In addition, the component (D) is more preferably at least one selected from the group consisting of an olefinic elastomer, a polyester-based elastomer, and a urethane-based elastomer.

### (Styrenic Elastomer)

Examples of the styrenic elastomer include a styrene-butadiene-styrene block copolymer, a styrene-isoprene-styrene block copolymer, a styrene-ethylene-butylene-styrene block copolymer, and a styrene-ethylene-propylene-styrene block copolymer. The styrenic elastomer may be used alone or may be used in combination of two or more thereof.

Examples of a component constituting the styrenic elastomer include styrene; and styrene derivatives, such as α-methylstyrene, 3-methylstyrene, 4-propylstyrene, and 4-cyclohexylstyrene.

The styrenic elastomer is preferably one having a number average molecular weight of 1,000 to 50,000, and more preferably one having a number average molecular weight of 3,000 to 20,000.

In this specification, the number average molecular weight is a value expressed in terms of standard polystyrene by the gel permeation chromatography (GPC) with tetrahydrofuran as a solvent.

As the styrenic elastomer, a commercially available product can be used.

### (Olefinic Elastomer)

The olefinic elastomer is a polymer or copolymer of an α-olefin having 2 to 20 carbon atoms, such as ethylene, propylene, 1-butene, 1-hexene, and 4-methyl-pentene. The olefinic elastomer may be one having a hydroxy group at a molecular terminal and is preferably one having a hydroxy group at a molecular terminal. The olefinic elastomer may be used alone or may be used in combination of two or more thereof.

As for the olefinic elastomer, there are suitably exemplified polyethylene, polybutadiene, a hydroxy group-containing polybutadiene, a hydroxy group-containing polyisopropylene, an ethylene-propylene copolymer (EPR), and an ethylene-propylene-diene copolymer (EPDM). In addition, there is also exemplified a copolymer of the α-olefin having 2 to 20 carbon atoms with a non-conjugated diene having 2 to 20 carbon atoms, such as dicyclopentadiene, 1,4-hexadiene, cyclooctadiene, methylene norbornene, ethylidene norbornene, butadiene, and isoprene. Furthermore, there is also exemplified a carboxy-modified NBR resulting from copolymerizing a butadiene-acrylonitrile copolymer with methacrylic acid, and so on.

The olefinic elastomer is preferably one having a number average molecular weight of 1,000 to 8,000, more preferably one having a number average molecular weight of 1,000 to 6,500, still more preferably one having a number average molecular weight of 1,000 to 5,000, and especially preferably one having a number average molecular weight of 1,500 to 3,500.

As the olefinic elastomer, a commercially available production can be used.

### (Polyester-based Elastomer)

Examples of the polyester-based elastomer include ones obtained by polycondensing a dicarboxylic acid or a derivative thereof with a diol compound or a derivative thereof. The polyester-based elastomer may be used alone or may be used in combination of two or more thereof.

Examples of the dicarboxylic acid include aromatic dicarboxylic acids, such as terephthalic acid, isophthalic acid, and naphthalene dicarboxylic acid; aromatic dicarboxylic acids resulting from substituting a hydrogen atom of the aforementioned aromatic dicarboxylic acid with a methyl group, an ethyl group, a phenyl group, or the like; aliphatic dicarboxylic acids having 2 to 20 carbon atoms, such as adipic acid, sebacic acid, and dodecane dicarboxylic acid; and alicyclic dicarboxylic acids, such as cyclohexane dicarboxylic acid. As for the dicarboxylic acid, from the viewpoint of adhesion to a base material, it is also preferred to use a dimer acid derived from a natural product. The dicarboxylic acid may be used alone or may be used in combination of two or more thereof.

Examples of the dicarboxylic acid derivative include acid anhydrides of the aforementioned dicarboxylic acids.

Examples of the diol compound include aliphatic diols, such as ethylene glycol, 1,3-propanediol, 1,4-butanediol, 1,6-hexanediol, and 1,10-decanediol; alicyclic diols, such as 1,4-cyclohexane diol; and aromatic diols represented by the following general formula (D-1). The diol compound may be used alone or may be used in combination of two or more thereof. 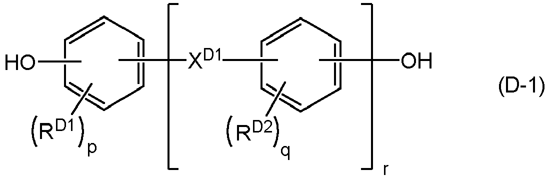 In the general formula (D-1), X^{D1} represents an alkylene group having 1 to 10 carbon atoms, an alkylidene group having 2 to 10 carbon atoms, a cycloalkylene group having 4 to 8 carbon atoms, -O-, -S-, or -SO₂-; R^{D1} and R^{D2} each independently represent a halogen atom or an alkyl group having 1 to 12 carbon atoms; p and q are each independently an integer of 0 to 4; and r is 0 or 1.

In the general formula (D-1), examples of the alkylene group having 1 to 10 carbon atoms, which is represented by X^{D1}, include a methylene group, a 1,2-dimethylene group, a 1,3-trimethylene group, a 1,4-tetramethylene group, and a 1,5-pentamethylene group. From the viewpoint of photosensitive characteristics, adhesion strength to plated copper, and electrical insulation reliability, the alkylene group is preferably an alkylene group having 1 to 3 carbon atoms, and more preferably a methylene group.

Examples of the alkylidene group having 2 to 10 carbon atoms, which is represented by X^{D1}, include an ethylidene group, a propylidene group, an isopropylidene group, a butylidene group, an isobutylidene group, a pentylidene group, and an isopentylidene group. From the viewpoint of photosensitive characteristics, adhesion strength to plated copper, and electrical insulation reliability, the alkylidene group is preferably an isopropylidene group.

Examples of the cycloalkylene group having 4 to 8 carbon atoms, which is represented by X^{D1}, include a cyclopentylene group, a cyclohexylene group, and a cyclooctylene group.

Among the foregoing, X^{D1} is preferably an alkylene group having 1 to 10 carbon atoms or an alkylidene group having 2 to 10 carbon atoms, and more preferably a methylene group or an isopropylidene group.

In the general formula (D-1), examples of the halogen atom which is represented by R^{D1} and R^{D2} include a fluorine atom, a chlorine atom, a bromine atom, and an iodine atom.

Examples of the alkyl group having 1 to 12 carbon atoms, which is represented by R^{D1} and R^{D2}, include a methyl group, an ethyl group, a n-propyl group, an isopropyl group, a n-butyl group, an isobutyl group, a t-butyl group, and a n-pentyl group. The alkyl group is preferably an alkyl group having 1 to 6 carbon atoms, more preferably an alkyl group having 1 to 3 carbon atoms, and still more preferably a methyl group.
p and q are each independently an integer of 0 to 4, and each preferably 0 or 1.
r is 0 or 1, and though it may be any of these. When r is 0, then the diol compound has a structure represented by the following general formula (D-1').

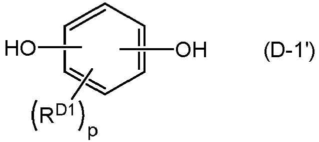

In the general formula (D-1'), X^{D1}, R^{D1}, and p are the same as those in the general formula (D-1), and preferred embodiments thereof are also the same.

Examples of the aromatic diol represented by the general formula (D-1) include bisphenol A, bis(4-hydroxyphenyl)methane, bis(4-hydroxy-3-methylphenyl)propane, and resorcin.

Furthermore, as the polyester-based elastomer, a multi-block copolymer containing an aromatic polyester (for example, polybutylene terephthalate) moiety as a hard segment component and an aliphatic polyester (for example, polytetramethylene glycol) moiety as a soft segment component can also be used, and it is preferred to use the foregoing multi-block copolymer.

The polyester-based elastomer is preferably one having a number average molecular weight of 900 to 30,000, more preferably one having a number average molecular weight of 1,000 to 25,000, and still more preferably one having a number average molecular weight of 5,000 to 20,000.

As the polyester-based elastomer, a commercially available product may be used.

### (Urethane-based Elastomer)

Suitable examples of the urethane-based elastomer include ones containing a hard segment composed of a short-chain diol and a diisocyanate and a soft segment composed of a high-molecular (long-chain) diol and a diisocyanate. The urethane-based elastomer may be used alone or may be used in combination of two or more thereof.

Examples of the high-molecular (long-chain) diol include polypropylene glycol, polytetramethylene oxide, poly(1,4-butylene adipate), poly(ethylene-1,4-butylene adipate), polycaprolactone, poly(1,6-hexylene carbonate), and poly(1,6-hexylene-neopentylene adipate). The number average molecular weight of the high-molecular (long-chain) diol is preferably 500 to 10,000.

Examples of the short-chain diol include ethylene glycol, propylene glycol, 1,4-butanediol, and bisphenol A. The number average molecular weight of the short-chain diol is preferably 48 to 500.

The urethane-based elastomer is preferably one having a number average molecular weight of 1,000 to 25,000, more preferably one having a number average molecular weight of 1,500 to 20,000, and still more preferably one having a number average molecular weight of 2,000 to 15,000.

As the urethane-based elastomer, a commercially available product may be used.

### (Polyamide-based Elastomer)

The polyamide-based elastomer is roughly classified into two types of a polyether block amide type in which a polyamide is used as the hard segment, and a polyether is used as the soft segment; and a polyether ester block amide type in which a polyamide is used as the hard segment, and a polyester is used as the soft segment.

Specific examples of the polyamide-based elastomer include block copolymers in which a polyamide is used as the hard segment component, and polybutadiene, a butadiene-acrylonitrile copolymer, a styrene-butadiene copolymer, polyisoprene, an ethylene-propylene copolymer, a polyether, a polyester, polybutadiene, a polycarbonate, a polyacrylate, a polymethacrylate, a polyurethane, a silicone rubber, or the like is used as the soft segment. The polyamide-based elastomer may be used alone or may be used in combination of two or more thereof.

The polyamide-based elastomer is preferably one having a number average molecular weight of 1,000 to 50,000, and more preferably one having a number average molecular weight of 2,000 to 30,000.

As the polyamide-based elastomer, a commercially available product may be used.

### (Acrylic Elastomer)

Examples of the acrylic elastomer include polymers of a raw material monomer composed of an acrylic ester as a main component. As the acrylic ester, there are suitably exemplified ethyl acrylate, butyl acrylate, methoxyethyl acrylate, ethoxyethyl acrylate, and so on. In addition, elastomers resulting from copolymerizing, as a crosslinking point monomer, glycidyl methacrylate, allyl glycidyl ether, etc. may be used, and elastomers resulting from further copolymerizing acrylonitrile, ethylene, etc. may be used. Specifically, examples thereof include an acrylonitrile-butyl acrylate copolymer, an acrylonitrile-butyl acrylate-ethyl acrylate copolymer, and an acrylonitrile-butyl acrylate-glycidyl methacrylate copolymer. The acrylic elastomer may be used alone or may be used in combination of two or more thereof.

The acrylic elastomer is one having a number average molecular weight of 1,000 to 50,000, and more preferably one having a number average molecular weight of 2,000 to 30,000.

### (Silicone-based Elastomer)

The silicone-based elastomer is an elastomer composed of an organopolysiloxane as a main component, and for example, it is classified into a polydimethylsiloxane-based elastomer, a polymethylphenylsiloxane-based elastomer, a polydiphenylsiloxane-based elastomer, and so on. The silicone-based elastomer may be used alone or may be used in combination of two or more thereof.

The silicone-based elastomer is preferably one having a number average molecular weight of 1,000 to 50,000, and more preferably one having a number average molecular weight of 2,000 to 30,000.

As the silicone-based elastomer, a commercially available product may be used.

### (Other Elastomers)

The component (D) may also be an embodiment including at least one selected from the group consisting of a polyphenylene ether resin, a phenoxy resin, a polycarbonate resin, a polyamide-imide resin, a polyimide resin, a xylene resin, a polyphenylene sulfide resin, a polyether imide resin, a polyetheretherketone resin, a tetrafluoroethylene resin, a polyacrylonitrile resin, a maleic anhydride-modified polybutadiene, a phenol-modified polybutadiene, and a carboxy-modified polyacrylonitrile.

### (Content of Component (D))

In the case where the photosensitive resin composition of the present embodiment contains the component (D), the content thereof is preferably 0.5 to 20% by mass, more preferably 1 to 20% by mass, still more preferably 1 to 15% by mass, especially preferably 1 to 10% by mass, and most preferably 1 to 6% by mass on the basis of the whole amount of the solid components of the photosensitive resin composition. When the content of the component (D) is 0.5% by mass or more, there is a tendency that not only the effect for improving the adhesion strength to plated copper becomes sufficient, but also the electrical insulation reliability becomes much more excellent. When the content of the component (D) is 20% by mass or less, there is a tendency that the photosensitive characteristics, the adhesion strength to plated copper, and the electrical insulation reliability become sufficient.

### <(E) Thermal Polymerization Initiator>

The photosensitive resin composition of the present embodiment may contain a thermal polymerization initiator as the component (E).

Although the thermal polymerization initiator is not particularly restricted, examples thereof include hydroperoxides, such as diisopropylbenzene hydroperoxide "PERCUMYL P" (a trade name, manufactured by NOF Corporation (hereinafter the same)), cumene hydroperoxide "PERCUMYL H", and t-butyl hydroperoxide "PERBUTYL H"; dialkyl peroxides, such as α,α-bis(t-butyl peroxy-m-isopropyl)benzene "PERBUTYL P", dicumyl peroxide "PERCUMYL D", 2,5-dimethyl-2,5-bis(t-butyl peroxy)hexane "PERHEXA 25B", t-butyl cumyl peroxide "PERBUTYL C", di-t-butyl peroxide "PERBUTYL D", 2,5-dimethyl-2,5-bis(t-butyl peroxy)hexyne-3 "PERHEXYNE 25B", and t-butyl peroxy-2-ethyl hexanoate "PERBUTYL O"; ketone peroxides; peroxy ketals, such as n-butyl 4,4-di-(t-butyl peroxy)valerate "PERHEXA V"; diacyl peroxides; peroxy dicarbonates; organic oxides, such as a peroxy ester; and azo compounds, such as 2,2'-azobisisobutyl nitrile, 2,2'-azobis(2-cyclopropyl propionitrile), and 2,2'-azobis(2,4-dimethyl valeronitrile). Of these, from the viewpoint that the photopolymerizability is not hindered and that the effect for improving the physical properties and characteristics of the photosensitive resin composition is large, dialkyl peroxides are preferred, and 2,5-dimethyl-2,5-bis(t-butyl peroxy)hexyne-3 is more preferred.

The thermal polymerization initiator may be used alone or may be used in combination of two or more thereof.

### (Content of Component (E))

In the case where the photosensitive resin composition of the present embodiment contains the component (E), though the content thereof is not particularly restricted, it is preferably 0.01 to 5% by mass, more preferably 0.02 to 3% by mass, and still more preferably 0.03 to 2% by mass on the basis of the whole amount of the resin components of the photosensitive resin composition. When the content of the component (E) is 0.01% by mass or more, there is a tendency that the thermal curing can be sufficiently performed, and when it is 5% by mass or less, there is a tendency that the photosensitive characteristics and the heat resistance become favorable.

### <(F) Inorganic Filler>

The photosensitive resin composition of the present embodiment may contain an inorganic filler as the component (F), and it preferably contains the inorganic filler. In view of the fact that the photosensitive resin composition contains the inorganic filler, the thermal-expansion reduction can be achieved, and a fear to generate warpage becomes less. In the thermosetting resin composition which has hitherto been used as the interlayer insulting layer of the multilayer wiring board, it has been contemplated to achieve the thermal-expansion reduction by containing an inorganic filler. However, when the inorganic filler is contained in the photosensitive resin composition, the inorganic filler causes scattering of light to possibly become an obstacle to the development. In this way, with respect to the matter of containing the inorganic filler, a new problem own to the photosensitive resin composition exists. However, according to the photosensitive resin composition of the present embodiment, even when the inorganic filler is contained, there is a tendency that the photosensitive characteristics become favorable. Accordingly, so far as the photosensitive resin composition of the present embodiment is concerned, it is possible to make both the thermal-expansion reduction and the photosensitive characteristics compatible with each other.

Examples of the component (F) include silica (SiO₂), alumina (Al₂O₃), titania (TiO₂), tantalum oxide (Ta₂O₅), zirconia (ZrO₂), silicon nitride (Si₃N₄), barium titanate (BaO·TiO₂), barium carbonate (BaCO₃), magnesium carbonate (MgCO₃), aluminum hydroxide (Al(OH)₃), magnesium hydroxide (Mg(OH)₂), lead titanate (PbO·TiO₂), lead zirconate titanate (PZT), lead lanthanum zirconate titanate (PLZT), gallium oxide (Ga₂O₃), spinel (MgO·Al₂O₃), mullite (3Al₂O₃.·2SiO₂), cordierite (2MgO·2Al₂O₃/5SiO₂), talc (3MgO·4SiO₂H₂O), aluminum titanate (TiO₂·Al₂O₃), yttria-containing zirconia (Y₂O₃·ZrO₂), barium silicate (BaO·8SiO₂), boron nitride (BN), calcium carbonate (CaCO₃), barium sulfate (BaSO₄), calcium sulfate (CaSO₄), zinc oxide (ZnO), magnesium titanate (MgO·TiO₂), hydrotalcite, mica, fired kaolin, and carbon. The component (F) may be used alone or may be used in combination of two or more thereof.

From the viewpoint of photosensitive characteristics, an average particle diameter of the component (F) is preferably 0.01 to 5 µm, more preferably 0.1 to 3 µm, still more preferably 0.1 to 2 µm, and especially preferably 0.1 to 1 pm. Here, the average particle diameter of the component (F) is a volume average particle diameter of the inorganic filler in a dispersed state in the photosensitive resin composition and is a value obtained through the following measurement. First, the photosensitive resin composition is diluted (or dissolved) with methyl ethyl ketone 1,000 times, particles dispersed in the solvent are measured with a submicron particle analyzer (a trade name: N5, manufactured by Beckman Coulter, Inc.) at a refractive index of 1.38 in conformity with International Standard ISO13321, and a particle diameter at an integrated value of 50% (volume basis) in the particle size distribution is defined as the average particle diameter (volume average particle diameter). In addition, with respect to the component (F) which is contained in the photosensitive resin film and the interlayer insulating layer provided on a support film, the average particle diameter can be measured by diluting (or dissolving) it with the aforementioned solvent 1,000 times (volume ratio) and then performing the measurement with the aforementioned submicron particle analyzer.

From the viewpoint of heat resistance and thermal-expansion reduction, the component (F) preferably includes silica and is more preferably silica. In addition, from the viewpoint of improving the dispersibility of the inorganic filler in the photosensitive resin composition due to the effect of preventing aggregation, one having been surface-treated with alumina or an organic silane-based compound may be used as the component (F).

### (Content of Component (F))

In the case where the photosensitive resin composition contains the component (F), though the content thereof is not particularly restricted, it is preferably 5 to 80% by mass, more preferably 5 to 60% by mass, still more preferably 8 to 45% by mass, especially preferably 10 to 30% by mass, and most preferably 10 to 20% by mass on the basis of the whole amount of the solid components of the photosensitive resin composition. When the content of the component (F) falls within the aforementioned range, the mechanical strength, the heat resistance, the low thermal expansion, the photosensitive characteristics, so on can be improved.

### <Pigment (G)>

The photosensitive resin composition of the present embodiment may contain a pigment as the component (G) according to a desired color for the purpose of controlling the photosensitivity, etc. A colorant capable of providing the desired color may be appropriately selected and used as the component (G), and for example, there are preferably exemplified known colorants, such as phthalocyanine blue, phthalocyanine green, iodine green, diazo yellow, crystal violet, titanium oxide, carbon black, and naphthalene black.

### (Content of Component (G))

In the case where the photosensitive resin composition of the present embodiment contains the component (G), the content thereof is preferably 0.01 to 15% by mass, more preferably 0.1 to 12% by mass, and still more preferably 3 to 10% by mass on the basis of the whole amount of the solid components of the photosensitive resin composition from the viewpoint of controlling the photosensitivity, etc.

### <Curing Agent (H)>

In the photosensitive resin composition of the present embodiment, a curing agent may be contained from the viewpoint of further improving various characteristics, such as heat resistance, adhesion strength to plated copper, and chemical resistance. In particular, in the case where the thermosetting resin (C) contains an epoxy resin, it is preferred to contain an epoxy resin curing agent as the curing agent.

Examples of the component (H) include imidazole derivatives, such as 2-methylimidazole, 2-ethyl-4-methylimidazole, 1-benzyl-methylimidazole, 2-phenylimidazole, and 2-phenyl-4-methyl-5-hydroxymethylimidazole; guanamines, such as acetoguanamine and benzoguanamine; polyamines, such as diaminodiphenylmethane, m-phenylenediamine, m-xylenediamine, diaminodiphenylsulfone, dicyandiamide, urea, a urea derivative, melamine, and a polybasic hydrazide; organic acid salts and/or epoxy adducts thereof; amine complexes, such as boron trifluoride; trizine derivatives, such as ethyldiamino-S-triazine, 2,4-diamino-S-triazine, and 2,4-diamino-6-xylyl-S-triazine; tertiary amines, such as trimethylamine, N,N-dimethyloctylamine, N-benzyldimethylamine, pyridine, N-methylmorpholine, hexa(N-methyl)melamine, 2,4,6-tris(dimethylaminophenol), tetramethylguanamine, and m-aminophenol; polyphenols, such as polyvinyl phenol, polyvinyl phenol bromide, phenol novolak, and an alkylphenol novolak; organic phosphines, such as tributyl phosphine, triphenyl phosphine, and tris-2-cyanoethyl phosphine; phosphonium salts, such as tri-n-butyl(2,5-dihydroxyphenyl)phosphonium bromide and hexadecyltributylphosphonium chloride; quaternary ammonium salts, such as benzyltrimethylammonium chloride and phenyltributylammonium chloride; the aforementioned polybasic acid anhydrides; diphenyliodonium tetrafluoroborate, triphenylsulfonium hexafluoroantimonate, and 2,4,6-triphenylthiopyrylium hexafluorophosphate.

Of these, polyamines are preferred, and melamine is more preferred from the viewpoint of more improving various characteristics, such as heat resistance, adhesion strength to plated copper, and chemical resistance.

In the case where the photosensitive resin composition of the present embodiment contains the component (H), the content thereof is preferably 0.01 to 30% by mass, more preferably 0.1 to 25% by mass, still more preferably 5 to 25% by mass, and especially preferably 10 to 25% by mass on the basis of the whole amount of the resin components of the photosensitive resin composition.

### <Diluent>

If desired, a diluent may be used in the photosensitive resin composition of the present embodiment. As the diluent, for example, an organic solvent, etc. can be used. Examples of the organic solvent include ketones, such as methyl ethyl ketone and cyclohexanone; aromatic hydrocarbons, such as toluene, xylene, and tetramethylbenzene; glycol ethers, such as methyl cellosolve, butyl cellosolve, methyl carbitol, butyl carbitol, propylene glycol monomethyl ether, dipropylene glycol monoethyl ether, dipropylene glycol diethyl ether, and triethylene glycol monoethyl ether; esters, such as ethyl acetate, butyl acetate, propylene glycol monoethyl ether acetate, butyl cellosolve acetate, and carbitol acetate; aliphatic hydrocarbons, such as octane and decane; and petroleum solvents, such as petroleum ether, petroleum naphtha, hydrogenated petroleum naphtha, and sorbent naphtha. The diluent may be used alone or may be used in combination of two or more thereof.

### (Content of Diluent)

The content of the diluent may be appropriately selected such that the concentration of the whole amount of the solid components in the photosensitive resin composition is preferably 40 to 90% by mass, more preferably 50 to 80% by mass, still more preferably 55 to 70% by mass, and especially preferably 55 to 65% by mass. By controlling the use amount of the diluent in this way, the coatability of the photosensitive resin composition is improved, thereby making it possible to form a higher-resolution pattern.

### <Other Additives>

If desired, the photosensitive resin composition of the present embodiment can contain various known common additives, such as a polymerization inhibitor, e.g., hydroquinone, methylhydroquinone, hydroquinone monomethyl ether, catechol, and pyrogallol; a tackifier, e.g., bentone and montmorillonite; and a defoaming agent, e.g., silicone-based defoaming agent, a fluorine-based defoaming agent, and a vinyl resin-based defoaming agent; and a silane coupling agent. Furthermore, the photosensitive resin composition may also contain a flame retardant, such as a brominated epoxy compound, an acid-modified brominated epoxy compound, an antimony compound, a phosphate compound of a phosphorus-based compound, an aromatic condensed phosphate ester, and a halogen-containing condensed phosphate ester.

The photosensitive resin composition of the present embodiment can be obtained by kneading and mixing the respective components in a roll mill, a bead mill, etc.

Here, the photosensitive resin composition of the present embodiment may be used in a liquid state or may be used in a film state.

In the case of using in a liquid state, though the coating method of the photosensitive resin composition of the present embodiment is not particularly restricted, examples thereof include various coating methods, such as a printing method, a spin coating method, a spray coating method, a jet dispense method, an ink jet method, and an immersion coating method. Of these, the coating method may be appropriately selected from a printing method and a spin coating method from the viewpoint of more easily forming the photosensitive layer.

In the case of using in a film state, for example, the photosensitive resin composition can be used in the form of a photosensitive resin film as mentioned later. In this case, a support film-provided photosensitive resin film having a photosensitive layer having a desired thickness can be formed by laminating on a support film using a laminator, etc. The method of using in a film state is preferred because the production efficiency of a multilayer printed wiring board becomes high.

### [Photosensitive Resin Film and Photosensitive Resin Film for Interlayer Insulating Layer]

The photosensitive resin film of the present embodiment is a photosensitive layer which will later become an interlayer insulating layer and is formed of the photosensitive resin composition of the present embodiment. The photosensitive resin film of the present embodiment may also be an embodiment in which the photosensitive resin film is provided on a support film.

Although a thickness (thickness after drying) of the photosensitive film (photosensitive layer) is not particularly limited, it is preferably 1 to 100 µm, more preferably 1 to 50 µm, and still more preferably 5 to 40 pm from the viewpoint of thinning of the multilayer printed wiring board.

The photosensitive resin film of the present embodiment is, for example, obtained by coating the photosensitive resin composition of the present embodiment on a support film using a known coating apparatus, such as comma coater, a bar coater, a kiss coater, a roll coater, a gravure coater, and a die coater, followed by drying to form the photosensitive layer which will later become an interlayer insulating layer.

Although the support film is not particularly restricted, examples thereof include polyester films, such as a polyethylene terephthalate film and a polybutylene terephthalate film; and polyolefin films, such as a polypropylene film and a polyethylene film. Of these, a polyester film is preferred, and a polyethylene terephthalate fil is more preferred. Although a thickness of the support film may be appropriately selected from a range of 5 to 100 µm, it is preferably 5 to 60 µm, and more preferably 15 to 45 pm.

The photosensitive resin film of the present embodiment can also be provided with a protective film on a surface of the photosensitive layer, which is located at the opposite side to a surface thereof coming into contact with the support film. As the protective film, a polymer film of, for example, polyethylene, or polypropylene, or the like can be used. In addition, a polymer film the same as the aforementioned support film may be used, or a different polymer film may also be used.

The coating film to be formed by coating the photosensitive resin composition can be dried with hot air or using a drier with far-infrared rays or near-infrared rays. A drying temperature is preferably 60 to 150°C, more preferably 70 to 120°C, and still more preferably 80 to 100°C. In addition, a drying time is preferably 1 to 60 minutes, more preferably 2 to 30 minutes, and still more preferably 5 to 20 minutes. The content of the remaining diluent in the photosensitive resin film after drying is preferably 3% by mass or less, more preferably 2% by mass or less, and still more preferably 1% by mass or less from the viewpoint of avoiding the diluent from diffusion in the production process of a multilayer printed wiring board.

Since the photosensitive resin film of the present embodiment is excellent in photosensitive characteristics and strippability from a support film, it is suited as the interlayer insulating layer of the multilayer printed wiring board. Namely, the present invention also provides a photosensitive resin film for interlayer insulating layer. The photosensitive resin film for interlayer insulating layer can also be referred to as an interlayer insulating photosensitive film.

### [Multilayer Printed Wiring Board and Method for Producing Same]

The present invention also provides a multilayer printed wiring board containing an interlayer insulating layer to be formed using the photosensitive resin composition or photosensitive resin film of the present embodiment. The multilayer printed wiring board of the present embodiment is not particularly restricted with respect to the method for producing the same so long as it includes a step of forming an interlayer insulating layer using the photosensitive resin composition of the present embodiment, and for example, it can be easily produced by the following method for producing the multilayer printed wiring board of the present embodiment.

As an example of the preferred embodiment of the production method of the multilayer printed wiring board, a method for producing a multilayer printed wiring board using the photosensitive resin film (photosensitive resin film for interlayer insulating layer) of the present embodiment will be described while appropriately referring to Fig. 1.

A multilayer printed wiring board 100A can be, for example, produced by a production method including the following steps (1) to (4):
Step (1): a step of laminating the photosensitive resin film of the present embodiment on one surface or both surfaces of a circuit substrate (hereinafter referred to as "lamination step (1)");
Step (2): a step of exposing and developing the photosensitive resin film laminated in the step (1), to form an interlayer insulating layer having a via (hereinafter referred to as "photo via forming step (2));
Step (3): a step of subjecting the via and the interlayer insulating layer to a roughening treatment (hereinafter referred to as "roughening treatment step (3)); and
Step (4): a step of forming a circuit pattern on the interlayer insulating layer (hereinafter referred to as "circuit pattern forming step (4)").

### (Lamination Step (1))

The lamination step (1) is a step of laminating the photosensitive resin film (photosensitive resin film for interlayer insulating layer) on one surface or both surfaces of a circuit substrate (substrate 101 having a circuit pattern 102) by using a vacuum laminator. Examples of the vacuum laminator include a vacuum applicator, manufactured by Nichigo-Morton Co., Ltd., a vacuum pressure type laminator, manufactured by Meiki Co., Ltd., a roll type dry coater, manufactured by Hitachi, Ltd., and a vacuum laminator, manufactured by Hitachi Chemical Electronics Co., Ltd.

In the case where a protective film is provided in the photosensitive resin film, after stripping or removing the protective film, the photosensitive resin film can be laminated by pressure bonding to the circuit substrate while pressurizing and heating so as to bring the photosensitive resin film into contact with the circuit substrate.

The lamination can be, for example, carried out at a pressure bonding temperature of 70 to 130°C and a pressure bonding pressure of 0.1 to 1.0 MPa under a reduced pressure of an air pressure of 20 mmHg (26.7 hPa) or less after optionally preliminarily heating the photosensitive resin film and the circuit substrate. However, the lamination is not particularly restricted to this condition. In addition, the lamination method may be in a batch mode or may be in a continuous mode with rolls.

Finally, the photosensitive resin film laminated on the circuit substrate (the photosensitive resin film will be hereinafter occasionally referred to as "photosensitive layer") is cooled to a temperature close to room temperature, to form an interlayer insulating layer 103. The support film may be stripped off here or may be stripped off after exposure as mentioned later.

### (Photo via Forming Step (2))

In the photo via forming step (2), at least a part of the photosensitive resin film laminated on the circuit substrate is exposed, followed by performing the development. The portion irradiated with actinic rays is photo-cured through the exposure, whereby a pattern is formed. The exposure method is not particularly restricted, and for example, a method of exposing imagewise actinic rays via a negative or positive mask pattern that is called an artwork (mask exposure method) may be adopted, or a method of exposing imagewise actinic rays by a direct drawing exposure method, such as an LDI (laser direct imaging) exposure method and a DLP (digital light processing) exposure method, may be adopted.

As a light source of the actinic rays, a known light source can be used. Specifically, examples of the light source include gas lasers, such as a carbon arc lamp, a mercury vapor arc lamp, a high-pressure mercury lamp, a xenon lamp, and an argon laser; solid lasers, such as a YAG laser; and ones of effectively radiating ultraviolet rays or visible light rays, such as a laser diode. Although the exposure amount is appropriately selected depending upon the light source used, the thickness of the photosensitive layer, etc., for example, in the case of irradiation with ultraviolet rays from a high-pressure mercury lamp, when the thickness of the photosensitive layer is 1 to 100 µm, the exposure amount is typically preferably about 10 to 1,000 mJ/cm², and more preferably 15 to 500 mJ/cm².

In the development, when an uncured portion of the photosensitive layer is removed from the top of the substrate, an interlayer insulating layer formed of a photo-cured cured product is formed on the substrate.

In the case where the support film exists in the photosensitive layer, after removing the support film, the removal (development) of the unexposed portion is performed. There are included wet development and dry development regarding the development method, and all of them may be adopted; however, the wet development is widely adopted, and the wet development can also be adopted in the present embodiment.

In the case of wet development, the development is performed by a known development method with a developer corresponding to the photosensitive resin composition. Examples of the development method include a dip method, a battle method, a spray method, blushing, slapping, scrapping, and agitation immersion. Of these, from the viewpoint of improving the resolution, a spray method is preferred, and a high-pressure spray method is more preferred as the spray method. The development may be carried out by a single method or may be carried out by a combination of two or more methods.

The constitution of the developer is appropriately selected according to the constitution of the photosensitive resin composition. Examples thereof include an alkaline aqueous solution, an aqueous developer, and an organic solvent-based developer, and of these, an alkaline aqueous solution is preferred.

In the photo via forming step (2), after performing the exposure and the development, by optionally performing post UV curing with an exposure amount of about 200 to 10,000 mJ/cm² (preferably 500 to 5,000 mJ/cm²) and post thermal curing at a temperature of about 60 to 250°C (preferably 120 to 200°C), the interlayer insulating layer may be further cured, and such is preferred.

There is thus formed an interlayer insulating layer having a via 104. The shape of the via is not particularly restricted, and when it is explained in terms of a cross-sectional shape, examples thereof include a quadrilateral and a reverse trapezoid (the top side is longer than the bottom side). When the shape of the via is explained in terms of a shape seen from the front (direction at which the via bottom is seen), examples thereof include a circle and a quadrilateral. In the formation of a via by the photolithography in the present embodiment, a via having a cross-sectional shape of a reverse trapezoid (the top side is longer than the bottom side) can be formed, and in this case, a throwing power on the via wall surface of plated copper becomes high, and hence, such is preferred.

The size (diameter) of the via formed by the present step can be controlled to less than 40 µm, and it is also possible to control it to 30 pm or less or 20 pm or less or 10 pm or less. In particular, it is advantageous to make it possible to control the foregoing size to 5 pm or less. In this way, it is possible to make the size smaller than that of a via prepared by laser processing. Although a lower limit of the size (diameter) of the via formed by the present step is not particularly restricted, it may be 15 pm or more or may be 20 pm or more.

However, the size (diameter) of the via formed by the present step is not always limited to less than 40 µm, for example, it may be about 200 pm or less, and for example, it is also possible to arbitrarily select it within a range of 15 to 300 pm.

### (Roughening Treatment Step (3))

In the roughening step (3), the via and the surface of the interlayer insulating layer are subjected to a roughening treatment with a roughening liquid. In the case where a smear is generated in the photo via forming step (2), the smear may be removed with the roughening liquid. The roughening treatment can be performed simultaneously with the removal of the smear.

Examples of the roughening liquid include a chromium/sulfuric acid roughening liquid, an alkaline permanganate roughening liquid (for example, a sodium permanganate roughening liquid), and a sodium fluoride/chromium/sulfuric acid roughening liquid.

An uneven anchor is formed on the via and the surface of the interlayer insulating surface through the roughening treatment.

### (Circuit Pattern Forming Step (4))

The circuit pattern forming step (4) is a step of after the roughening treatment step (3), forming a circuit pattern on the interlayer insulating layer.

From the viewpoint of forming a micro wiring, it is preferred to carry out the formation of a circuit pattern through a semi-additive process. According to the semi-additive process, conduction of the via is performed along with the formation of a circuit pattern.

In the semi-additive process, the via bottom, the via wall surface, and the entire surface of the interlayer insulating layer after the roughening treatment step (3) are subjected to an electroless copper plating treatment using a palladium catalyst, etc., to form a seed layer 105. The seed layer is one for forming a power supply layer for the purpose of performing copper electroplating and is preferably formed in a thickness of about 0.1 to 2.0 pm. When the thickness of the seed layer is 0.1 pm or more, there is a tendency that reduction in connection reliability during copper electroplating can be suppressed, and when it is 2.0 pm or less, it is not needed to increase the etching amount during flash etching of the seed layer between the wirings, and there is a tendency that the damage to give the wiring during etching is suppressed.

The electroless copper plating treatment is performed when metallic copper is deposited on the via and the surface of the interlayer insulating layer due to the reaction between a copper ion and a reducing agent.

The electroless plating treatment method and the electroplating treatment method may be performed by known methods and are not particularly limited. However, the catalyst in the electroless plating treatment step is preferably a palladium-tin mixture catalyst, and a primary particle diameter of the catalyst is preferably 10 nm or less. In addition, as for the plating composition of the electroless plating treatment step, it is preferred that hypophosphorous acid is contained as the reducing agent.

As the electroless copper plating solution, a commercially available product can be used, and examples of the commercially available product include "MSK-DK", manufactured by Atotech Japan K.K.; and "THRU-CUP (registered trademark) PEA ver.4" Series, manufactured by C.Uyemura & Co., Ltd.

After performing the electroless copper plating treatment, a dry film resist is subjected to thermocompression bonding on the electroless plated copper by using a roll laminator. The thickness of the dry film resist must be made higher than the height of the wiring after copper electroplating, and from this viewpoint, a dry film resist having a thickness of 5 to 30 pm is preferred. As for the dry film resist, for example, "PHOTEC" Series, manufactured by Hitachi Chemical Company, Ltd. is used.

After thermocompression bonding of the dry film resist, for example, the dry film resist is exposed through a mask having a desired wiring pattern drawn therein. The exposure can be performed by using the same apparatus and light source as those which may be used during forming a via on the photosensitive resin film. After the exposure, the carrier film on the dry film resist is stripped off, the residue is developed with an alkaline aqueous solution, and an unexposed portion is removed to form a resist pattern 106. Thereafter, if desired, a work of removing a development residue of the dry film resist using a plasma, etc. may be performed.

After the development, copper electroplating is performed, thereby achieving the formation and via filling of a circuit layer 107 of copper.

After the copper electroplating, the drying film resist is stripped off by using an alkaline aqueous solution or an amine-based stripping agent. After stripping off the dry film resist, removal (flash etching) of the seed layer between the wirings is performed. The flash etching is performed by using an acidic solution of sulfuric acid, hydrogen peroxide, etc. and an oxidative solution. Specifically, examples thereof include "SAC", manufactured by JCU Corporation; and "CPE-800", manufactured by Mitsubishi Gas Chemical Company, Inc. After the flash etching, if desired, removal of palladium, etc. deposited in the portion between the wirings is performed. The removal of palladium can be preferably performed by using an acidic solution of nitric acid, hydrochloric acid, etc.

After stripping of the dry film resist or flash etching step, a post-baking treatment is preferably performed. According to the post-baking treatment, an unreacted thermosetting component is thoroughly thermally cured, whereby the electrical insulation reliability, the curing characteristics, and the adhesion strength to plated copper are improved. Although the thermal curing condition varies with the kind of the resin composition, and the like, it is preferred that the curing temperature is 150 to 240°C, and the curing time is 15 to 100 minutes. According to the post-baking treatment, the general production step of the printed wiring board by the photo via method is accomplished; however, the substrate is produced by repeating this process according to the number of required interlayer insulating layers. Then, a solder resist layer 108 is preferably formed on the outermost layer.

In the light of the above, while the method for producing a multilayer printed wiring board in which a via is formed using the photosensitive resin composition of the present embodiment has been described, since the photosensitive resin composition of the present embodiment is excellent in pattern resolution, for example, it is also suitable for forming a cavity for the purpose of internally containing a chip or a passive element, etc. For example, the cavity can be suitably formed in a manner in which in the aforementioned explanation regarding the multilayer printed wiring board, the drawing pattern during exposing the photosensitive resin film to form a pattern is formed into one capable of forming a desired cavity.

Furthermore, the photosensitive resin composition of the present embodiment is also useful as a surface protective film of a solder resist, etc.

### [Semiconductor Package]

The present invention also provides a semiconductor package including the multilayer printed wiring board of the present embodiment having a semiconductor element mounted thereon. The semiconductor package of the present embodiment can be produced by mounting a semiconductor element, such as a semiconductor chip and a memory, at a predetermined position of the multilayer printed wiring board of the present invention and sealing the semiconductor element with a sealing resin, etc.

### Examples

The present invention is hereunder described in more detail by reference to Examples, but it should be construed that the present invention is not limited to these Examples.

Photosensitive resin compositions obtained in the respective Examples were evaluated with respect to characteristics by the following methods.

### {1. Evaluation of Photosensitive Characteristics (Resolution of Via)}

Onto a 1.0 mm-thick copper-cladded laminate substrate (MCL-E-67, manufactured by Hitachi Chemical Company, Ltd.), a support film and protective film-provided photosensitive resin film prepared in each of the Examples was laminated using a press type vacuum laminator (a product number: MVLP-500, manufactured by Meiki Co., Ltd.) while stripping off the protective film (protective layer), to obtain a laminate having a photosensitive layer. The condition of the lamination was set such that a pressure bonding pressure was 0.4 MPa, a press hot plate temperature was 75°C, an evacuation time was 40 seconds, a lamination press time was 60 seconds, and an atmospheric pressure was 4 kPa or less.

Subsequently, using an i-ray exposure apparatus (a product number: UX-2240SM-XJ-01, manufactured by Ushio Inc.), exposure was performed in a range of 100 to 500 mJ/cm² at every interval of 50 mJ/cm² through a negative mask having a via pattern of a predetermined size (aperture diameter size: 1, 2, 3, 4, 5, 6, 7, 8, 9, 10, 12, and 15 µm). Thereafter, the resultant was spray-developed with a 1 mass% sodium carbonate aqueous solution for a time corresponding to two times of a shortest development time (shortest time for which an unexposed area of the photosensitive layer was removed) at 30°C under a pressure of 1.765 × 10⁵ Pa, thereby dissolving the unexposed area through development. Subsequently, the resultant was exposed with a UV exposure apparatus at an exposure dose of 2,000 mJ/cm² and then heated at 170°C for one hour, thereby preparing a test piece of a cured product having the photosensitive resin composition on the copper-cladded laminate substrate at a via pattern of a predetermined size. The formed via pattern was observed and evaluated according to the following evaluation criteria. The evaluation with a grade "A" means that the photosensitive characteristics are excellent.
A: A minimum diameter of the aperture was 5 pm or less.
C: A minimum diameter of the aperture was 6 pm or more.

### [2. Evaluation of Strippability from Support Film]

Onto a 1.0 mm-thick copper-cladded laminate substrate (MCL-E-67, manufactured by Hitachi Chemical Company, Ltd.), a support film and protective film-provided photosensitive resin film prepared in each of the Examples was laminated using a press type vacuum laminator (a product number: MVLP-500, manufactured by Meiki Co., Ltd.) while stripping off the protective film (protective layer), to obtain a laminate having a photosensitive layer. The condition of the lamination was set such that a pressure bonding pressure was 0.4 MPa, a press hot plate temperature was 75°C, an evacuation time was 40 seconds, a lamination press time was 20 seconds, and an atmospheric pressure was 4 kPa or less.

Using a compact table-top universal tester (a product number: EZ-SX, manufactured by Shimadzu Corporation), a stripping force test of stripping the support film from the photosensitive layer was performed under a predetermined stripping condition (stripping angle: 180°, stripping rate: 0.2 m/min). A maximum value of a stress per 25 mm of width was recorded as the stripping force of the protective layer and evaluated according to the following criteria. From the viewpoint that as the stripping force between the support film and the photosensitive layer is high, a defect is readily generated in the image pattern to be used using a photoresist, the evaluation was made according to the following evaluation criteria.
A: The stripping force is 0.01 N/25 mm or more and 0.5 N/25 mm or less.
B: The stripping force is more than 0.5 N/25 mm and 1.0 N/25 mm or less.
C: The stripping force is more than 1.0 N/25 mm.

### <Synthesis Example 1> Synthesis of acid-modified ethylenically unsaturated group and alicyclic structure-containing epoxy derivative 1 [Component (A1-1)]

250 parts by mass of a dicyclopentadiene type epoxy resin ["XD-1000", manufactured by Nippon Kayaku Co., Ltd., epoxy equivalent: 252 g/eq, softening point: 74.2°C, corresponding to the component (a1) and represented by the general formula (a1-1), ring-forming carbon number of alicyclic structure: 10], 70 parts by mass of acrylic acid (corresponding to the component (a2)), 0.5 parts by mass of methyl hydroquinone, and 120 parts by mass of carbitol acetate were charged and allowed to react with each other by heating at 90°C and stirring, thereby completely dissolving the mixture.

Subsequently, the obtained solution was cooled to 60°C, 2 parts by mass of triphenyl phosphine was added, and the mixture was heated at 100°C to perform the reaction until an acid value of the solution became 1 mgKOH/g. To the solution after the reaction, 98 parts by mass of tetrahydrophthalic anhydride (corresponding to the component (a3)) and 85 parts by mass of carbitol acetate were added, and the mixture was heated at 80°C to perform the reaction for 6 hours.

Thereafter, the resultant was cooled to room temperature to obtain acid-modified dicyclopentadiene type epoxy acrylate having a solid component concentration of 73% by mass (corresponding to the component (A1-1), hereinafter referred to as "acid-modified ethylenically unsaturated group and alicyclic structure-containing epoxy derivative 1").

### <Examples 1 to 6 and Comparative Examples 1 to 4>

### (Preparation of Photosensitive Resin Composition)

Compositions were formulated according to the compounding formulation and compounding amount shown in Table 1, and kneaded each in a 3-roll mill to prepare photosensitive resin compositions. In each of the Examples, carbitol acetate was appropriately added to adjust the concentration, thereby obtaining a photosensitive resin composition having a solid component concentration of 60% by mass.

### (Preparation of Photosensitive Resin Film)

Using a 16 µm-thick polyethylene terephthalate film (a trade name: G2-16, manufactured by Teijin Limited) as a support film, the photosensitive resin composition prepared in each of the Examples was coated on the support film such that a film thickness after drying was 5 µm, and dried using a hot air convention drier at 75°C for 30 minutes, to form a photosensitive resin film (photosensitive layer). Continuously, on the surface of the photosensitive resin film (photosensitive layer) at the opposite side to the side coming into contact with the support film, a polyethylene film (a trade name: NF-15, manufactured by Tamapoly Co., Ltd.) was stuck as a protective film, to prepare a photosensitive resin film having the support film and the protective film stuck thereon.

Using the thus-prepared photosensitive resin films, the respective evaluations were performed according to the aforementioned methods. The results are shown in Table 1.

**Table 1**

| | | | | Unit | Example | | | | | | Comparative Example | | | |
|---|---|---|---|---|---|---|---|---|---|---|---|---|---|---|
| | | | | | 1 | 2 | 3 | 4 | 5 | 6 | 1 | 2 | 3 | 4 |
| | (A) | (A1-1) | Acid-modified ethylenically unsaturated group and alicyclic structure-containing epoxy derivative 1 | parts by mass | 55.93 | 55.93 | 55.93 | 55.93 | 55.93 | 55.93 | 55.93 | 55.93 | 55.93 | 55.93 |
| | | (Aiii) | Dipentaerythritol pentaacrylate | parts by mass | 5.82 | 5.82 | 5.82 | 5.82 | 5.82 | 5.82 | 5.82 | 5.82 | 5.82 | 5.82 |
| | (B) | Photopolymerization initiator 1 | | parts by mass | 1.21 | 1.21 | 1.21 | 1.21 | 1.21 | 1.21 | 1.21 | 1.21 | 1.21 | 1.21 |
| | | Photopolymerization initiator 2 | | parts by mass | 0.08 | 0.08 | 0.08 | 0.08 | 0.08 | 0.08 | 0.08 | 0.08 | 0.08 | 0.08 |
| | | Photopolymerization initiator 3 | | parts by mass | 0.04 | 0.04 | 0.04 | 0.04 | 0.04 | 0.04 | 0.04 | 0.04 | 0.04 | 0.04 |
| Photosensitive resin composition | (C) | (C1) | Alicyclic structure-containing epoxy resin | parts by mass | 6.85 | 10.99 | 15.13 | 19.26 | 8.80 | 6.85 | | | 5.50 | |
| | | (C2) | Biphenyl type epoxy resin | parts by mass | | | | | 2.20 | | 10.99 | | | |
| | | | Naphthalene type epoxy resin | parts by mass | | | | | | | | 10.99 | 5.50 | |
| | (F) | Silica | | parts by mass | | | | | | 13.41 | | | | |
| | (G) | Pigment | | parts by mass | 8.30 | 8.30 | 8.30 | 8.30 | 8.30 | 8.30 | 8.30 | 8.30 | 8.30 | 8.30 |
| | (H) | Curing agent | | parts by mass | 21.78 | 21.78 | 21.78 | 21.78 | 21.78 | 21.78 | 21.78 | 21.78 | 21.78 | 21.78 |
| Content of component (C1) based on 100 parts by mass of component (A) | | | | parts by mass | 11.1 | 17.8 | 24.5 | 31.2 | 14.3 | 11.1 | 0 | 0 | 8.9 | 0 |
| Evaluation results | (1) Photosensitive characteristics (resolution of via) | | | - | A | A | A | A | A | A | C | C | c | c |
| | (2) Strippability from support film | | | - | A | A | A | A | A | A | C | B | C | - |

| | | | | | | | | | | | | | | |
|---|---|---|---|---|---|---|---|---|---|---|---|---|---|---|
| • The compounding amount of each of the aforementioned components is a value expressed in terms of a solid component in the case of a solution. | | | | | | | | | | | | | | |

The respective components used in the respective Examples are as follows.
(A) Component;
   - Acid-modified ethylenically unsaturated group and alicyclic structure-containing epoxy derivative 1 [Component (A1-1)]: One obtained in Synthesis Example 1 was used.
   - Dipentaerythritol pentaacrylate [Component (Aiii)]
(B) Component;
   - Photopolymerization initiator 1:
      2-Methyl-1-[4-(methylthio)phenyl]-2-morpholino-1-propanone, acetophenones
   - Photopolymerization initiator 2:
      Bis(2,4,6-trimethylbenzoyl)phenyl phosphine oxide, acyl phosphine oxides
   - Photopolymerization initiator 3:
      1-[9-Ethyl-6-(2-methylbenzoyl)-9H-carbazol-3-yl]ethanone 1-(O-acetyloxime) (see the following structure), oxime esters 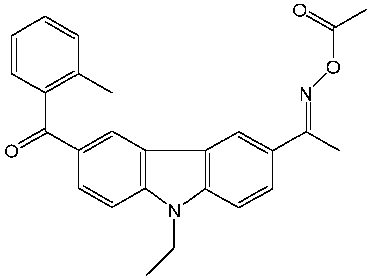
(C) Component;
   - Alicyclic structure-containing epoxy resin: "XD-1000", dicyclopentadiene type epoxy resin (a trade name, manufactured by Nippon Kayaku Co., Ltd., epoxy equivalent: 252 g/eq, softening point: 74.2°C
   - Biphenyl type epoxy resin: "YX-4000" (a trade name, manufactured by Mitsubishi Chemical Corporation)
   - Naphthalene type epoxy resin: "HP-4710" (a trade name, manufactured by DIC Corporation)
(F) Component;
   - Silica: "SFP-20M" (a trade name, average particle diameter: 0.3 µm, manufactured by Denka Company Limited)
(G) Component;
   - Pigment: C.I. Pigment Blue 15 (phthalocyanine-based pigment, a trade name, manufactured by Sanyo Color Works, LTD.)
(H) Component;
   - Curing agent: Finely pulverized melamine (a trade name, manufactured by Nissan Chemical Industries, Ltd.)

It is understood from Table 1 that according to the Examples, vias having a small diameter as 5 pm or less can be formed owing to the collective formation of vias by the photolithography and that the results reveal that not only the photosensitive characteristics (resolution of via) but also the strippability from a support film is excellent. On the other hand, in Comparative Examples 1, 2, and 4 not containing the component (C1) and Comparative Example 3 in which the content of the component (C1) is low, the strippability from a support film was poor, and the photosensitive characteristics (resolution of via) were worsened.

### Reference Signs List

100A: Multiplayer printed wiring board
102: Circuit pattern
103: Interlayer insulating layer
104: Via (via hole)
105: Seed layer
106: Resist pattern
107: Circuit layer of copper
108: Solder resist layer

## Claims

1. A photosensitive resin composition comprising (A) a photopolymerizable compound having an ethylenically unsaturated group, (B) a photopolymerization initiator, and (C) a thermosetting resin, wherein
the photopolymerizable compound (A) having an ethylenically unsaturated group includes (A1) a photopolymerizable compound having an acidic substituent and an alicyclic structure together with an ethylenically unsaturated group; and further, the thermosetting resin (C) includes (C1) a thermosetting resin having an alicyclic structure, and the content of the component (C1) is 10 parts by mass or more based on 100 parts by mass of the component (A).

2. The photosensitive resin composition according to claim 1, wherein the photopolymerizable compound (A) having an ethylenically unsaturated group further includes at least one selected from the group consisting of (Ai) a monofunctional vinyl monomer having one polymerizable ethylenically unsaturated group, (Aii) a bifunctional vinyl monomer having two polymerizable ethylenically unsaturated groups, and (Aiii) a polyfunctional vinyl monomer having at least three polymerizable ethylenically unsaturated groups.

3. The photosensitive resin composition according to claim 1 or 2, wherein in both the photopolymerizable compound (A1) having an acidic substituent and an alicyclic structure together with an ethylenically unsaturated group and the thermosetting resin (C 1) having an alicyclic structure, the alicyclic structure is an alicyclic structure having a ring-forming carbon number of 5 to 20.

4. The photosensitive resin composition according to claim 1 or 2, wherein in both the photopolymerizable compound (A1) having an acidic substituent and an alicyclic structure together with an ethylenically unsaturated group and the thermosetting resin (C1) having an alicyclic structure, the alicyclic structure is composed of two or more rings.

5. The photosensitive resin composition according to claim 1, 2, or 4, wherein in both the photopolymerizable compound (A1) having an acidic substituent and an alicyclic structure together with an ethylenically unsaturated group and the thermosetting resin (C1) having an alicyclic structure, the alicyclic structure is composed of three rings.

6. The photosensitive resin composition according to any one of claims 1 to 5, wherein in both the photopolymerizable compound (A1) having an acidic substituent and an alicyclic structure together with an ethylenically unsaturated group and the thermosetting resin (C1) having an alicyclic structure, the alicyclic structure is represented by the following general formula (a): 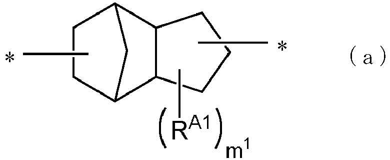 wherein R^{A1} represents an alkyl group having 1 to 12 carbon atoms and may be substituted in any site in the alicyclic structure; m¹ is an integer of 0 to 6; and * is a binding site to other structure.

7. The photosensitive resin composition according to any one of claims 1 to 6, wherein the photopolymerizable compound (A1) having an acidic substituent and an alicyclic structure together with an ethylenically unsaturated group is represented by the following general formula (A-1): 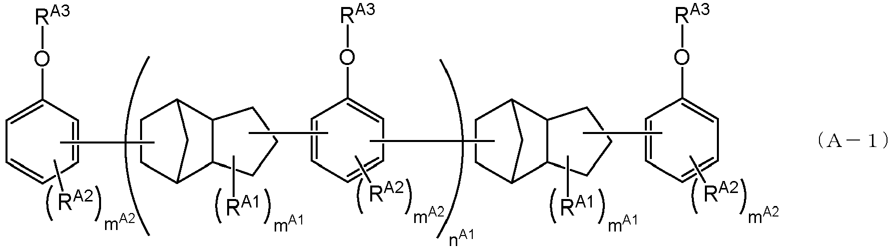 wherein R^{A1} represents an alkyl group having 1 to 12 carbon atoms and may be substituted in any site in the alicyclic structure; R^{A2} represents an alkyl group having 1 to 12 carbon atoms; R^{A3} is an organic group having an ethylenically unsaturated group, an organic group having an ethylenically unsaturated group and an acidic substituent, or a glycidyl group, and at least one R^{A3} is an organic group having an ethylenically unsaturated group and an acidic substituent; m^{A1} is an integer of 0 to 6; m^{A2} is an integer of 0 to 3; and n^{A1} is 0 to 10.

8. The photosensitive resin composition according to any one of claims 1 to 7, wherein in the photopolymerizable compound (A1) having an acidic substituent and an alicyclic structure together with an ethylenically unsaturated group, the acidic substituent is at least one selected from the group consisting of a carboxy group, a sulfonic acid group, and a phenolic hydroxy group.

9. The photosensitive resin composition according to any one of claims 1 to 8, wherein the thermosetting rein (C1) having an alicyclic structure is represented by the following general formula (C-1): 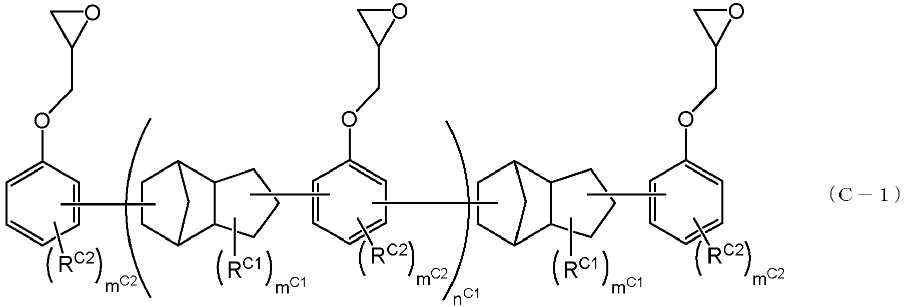 wherein R^{C1} represents an alkyl group having 1 to 12 carbon atoms and may be substituted in any site in the alicyclic structure; R^{C2} represents an alkyl group having 1 to 12 carbon atoms; m^{C1} is an integer of 0 to 6; m^{C2} is an integer of 0 to 3; and n^{C1} is 0 to 10.

10. The photosensitive resin composition according to any one of claims 1 to 9, further comprising (F) an inorganic filler.

11. The photosensitive resin composition according to any one of claims 1 to 10, further comprising (G) a curing agent.

12. A photosensitive resin composition for photo via formation, consisting of the photosensitive resin composition according to any one of claims 1 to 11.

13. A photosensitive resin composition for interlayer insulating layer, consisting of the photosensitive resin composition according to any one of claims 1 to 11.

14. A photosensitive resin film consisting of the photosensitive resin composition according to any one of claims 1 to 11.

15. A photosensitive resin film for interlayer insulating layer, consisting of the photosensitive resin composition according to any one of claims 1 to 11.

16. A multilayer printed wiring board comprising an interlayer insulating layer formed of the photosensitive resin composition according to any one of claims 1 to 11.

17. A multilayer printed wiring board comprising an interlayer insulating layer formed of the photosensitive resin film according to claim 14.

18. A semiconductor package comprising the multilayer printed wiring board according to claim 16 or 17 having a semiconductor element mounted thereon.

19. A method for producing a multilayer printed wiring board, comprising the following steps (1) to (4):
Step (1): a step of laminating the photosensitive resin film according to claim 14 on one surface or both surfaces of a circuit substrate;
Step (2): a step of exposing and developing the photosensitive resin film laminated in the step (1), to form an interlayer insulating layer having a via;
Step (3): a step of subjecting the via and the interlayer insulating layer to a roughening treatment; and
Step (4): a step of forming a circuit pattern on the interlayer insulating layer.
